(19) **Europäisches Patentamt / European Patent Office / Office européen des brevets**

(11) **EP 2 592 668 B1**

(12) **FASCICULE DE BREVET EUROPEEN**

(45) Date de publication et mention de la délivrance du brevet:
**14.05.2014 Bulletin 2014/20**

(51) Int Cl.:
**H01L 35/32** (2006.01)  **H01L 35/16** (2006.01)
**H01L 35/34** (2006.01)

(21) Numéro de dépôt: **12191991.4**

(22) Date de dépôt: **09.11.2012**

(54) **Ame thermoélectrique, structure thermoélectrique comprenant ladite ame, son procédé de réalisation et ses utilisations**

Thermoelektrischer Kern, thermoelektrische Struktur, die diesen Kern umfasst, ihr Herstellungsverfahren und ihre Einsatzmöglichkeiten

Thermoelectric core, thermoelectric structure including said core, method for manufacturing same and uses thereof

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.11.2011 FR 1160295**

(43) Date de publication de la demande:
**15.05.2013 Bulletin 2013/20**

(73) Titulaire: **ACOME Société coopérative et participative Société anonyme coopérative de production à capital variable**
**75014 Paris (FR)**

(72) Inventeurs:
 • **Ait Ameur, Mehdi**
  **50140 Romagny (FR)**
 • **Schoeffler, Francois**
  **50600 Parigny (FR)**
 • **Fillatre, Daniel**
  **50140 Romagny (FR)**
 • **Goupil, Christophe**
  **14200 Herouville Saint Clair (FR)**
 • **Gascoin, Franck**
  **14280 Saint Germain La Blanche Herbe (FR)**
 • **Tedenac, Jean-Claude**
  **34070 Montpellier (FR)**
 • **Fraisse, Gilles**
  **73000 Jacob-Bellecombette (FR)**
 • **Cornu, David**
  **34270 Les Matelles (FR)**
 • **Ruiz-Theron, Elodie**
  **34000 Montpellier (FR)**
 • **Ramousse, Julien**
  **73000 Chambery (FR)**
 • **Sgorlon, Damien**
  **73000 Montagnole (FR)**

(74) Mandataire: **Cabinet Plasseraud**
 **52, rue de la Victoire**
 **75440 Paris Cedex 09 (FR)**

(56) Documents cités:
 WO-A1-2004/105146   WO-A1-2009/023776
 WO-A2-2009/029393   DE-A1-102009 013 692
 FR-A1- 2 620 573   JP-A- 4 101 472
 JP-A- 8 032 124   US-A- 5 228 923
 US-A1- 2007 125 413   US-A1- 2010 095 997
 US-B2- 6 759 587

 • DASAROYONG KIM ET AL: "Improved Thermoelectric Behavior of Nanotube-Filled Polymer Composites with Poly(3,4-ethylenedioxythiophene) Poly (styrenesulfonate)", ACS NANO, vol. 4, no. 1, 26 janvier 2010 (2010-01-26), pages 513-523, XP055028192, ISSN: 1936-0851, DOI: 10.1021/nn9013577
 • GUERRERO V H ET AL: "Thermoelectric property tailoring by composite engineering", JOURNAL OF MATERIALS SCIENCE, SPRINGER NETHERLANDS, NL, vol. 37, no. 19, 1 octobre 2002 (2002-10-01), pages 4127-4136, XP002505017, ISSN: 0022-2461, DOI: 10.1023/A: 1020083718789

- CHATTERJEE K ET AL: "Synthesis and characterization of an electro-deposited polyaniline-bismuth telluride nanocomposite - A novel thermoelectric material", MATERIALS CHARACTERIZATION, ELSEVIER, NEW YORK, NY, US, vol. 60, no. 12, 1 décembre 2009 (2009-12-01), pages 1597-1601, XP026737329, ISSN: 1044-5803, DOI: 10.1016/J.MATCHAR. 2009.09.012 [extrait le 2009-09-27]

**Description**

La présente invention concerne une âme thermoélectrique, une structure thermoélectrique comprenant ladite âme, un procédé de réalisation de ladite structure thermoélectrique ainsi que ses utilisations.

L'effet thermoélectrique est un phénomène physique présent dans certains matériaux qui lie le flux de chaleur qui les traverse au courant électrique qui les parcourt. Ainsi un matériau thermoélectrique va permettre de transformer directement de la chaleur en électricité (effet Seebeck), ou inversement de générer de la chaleur par l'application d'un champ électrique (effet Peltier).

Un matériau thermoélectrique est caractérisé par sa figure de mérite définie de la manière suivante :

$$ZT = \frac{\alpha^2 T}{\rho\lambda}$$

où $\alpha$ est le coefficient de Seebeck (V.K$^{-1}$)
$\rho$ est la résistivité électrique ($\Omega$.m)
$\lambda$ est la conductivité thermique (W.m$^{-1}$.K$^{-1}$)

Un bon matériau thermoélectrique est un matériau qui présente une figure de mérite élevée, autrement dit il s'agit d'un matériau présentant un coefficient de Seebeck élevé, une résistivité électrique faible ainsi qu'une conductivité thermique faible.

Depuis plusieurs décennies, les modules à effet Peltier/Seebeck sont constitués de couples de jambes thermoélectriques connectés électriquement par un matériau conducteur. Chaque couple comprend une jambe d'un matériau semi-conducteur de type p et une jambe d'un matériau semi-conducteur de type n.

Bien que ces modules soient largement utilisés, ils présentent de nombreux inconvénients. En effet, ces derniers sont de dimensions décimétriques (car les 3 dimensions des jambes traditionnelles sont en mm) et conviennent donc seulement pour des applications mettant en oeuvre des densités de flux de chaleur jusqu'à une dizaine de watt par cm$^2$.

Ainsi, sous leur forme actuellement commercialisée, les modules Peltier sont de faibles dimensions et nécessitent donc d'être insérés dans un système complet comportant un échangeur permettant de transférer des densités de flux très importantes (jusqu'à une centaine de kilowatt par m$^2$), rendant ainsi les procédés de fabrication de ces dispositifs onéreux.

C'est pourquoi, depuis quelques années, on assiste à un renouveau important des recherches scientifiques dédiées à des structures thermoélectriques visant à trouver de nouvelles architectures de structures non seulement performantes (en choisissant un matériau thermoélectrique présentant de bonnes propriétés thermoélectriques), économiques mais également faciles à mettre en oeuvre (c'est-à-dire présentant de bonnes propriétés mécaniques).

A titre d'exemple, on peut citer le document GB 1455340 qui décrit une structure multicouches comprenant un substrat et des matériaux semi-conducteurs de type p ou n déposés de part et d'autre dudit substrat. Dans ce dispositif, le substrat est plié en accordéon et est fixé à des plaques de transfert thermique au niveau des plis où sont formées des rangées de trous permettant ainsi la conduction électrique. Cependant, le caractère compact du pliage en accordéon de ce dispositif offre une surface d'échange limitée avec les plaques de transfert thermique.

On peut également citer le document US4859250 qui divulgue une structure multicouches pliée au niveau de zones définissant des bandes froides ou chaudes où sont agencées une pluralité de bandes conductrices en contact avec deux parois, lesdites bandes conductrices interconnectant des matériaux thermoélectriques. Là encore, la structure de ce dispositif est telle que la surface d'échange est réduite entre la structure intérieure et les parois.

On peut également citer le document WO2009/023776 qui décrit une structure thermoélectrique comprenant des éléments de type p consistant en des nanotubes de carbone et des éléments de type n. La structure décrite dans ce document présente l'avantage d'être moins dense que les matériaux classiquement utilisés. En revanche, cette structure est nanostructurée conduisant à des procédés de fabrication coûteux et difficiles à mettre en oeuvre.

Ainsi, afin de disposer de dispositifs performants, un compromis entre de bonnes propriétés mécaniques (souplesse, rigidité, bonne aptitude de mise en forme) et de bonnes propriétés thermoélectriques doit être trouvé. C'est pourquoi, la nature des matériaux thermoélectriques contenus dans une structure thermoélectrique est un facteur également très important à considérer.

Concernant la nature du matériau thermoélectrique, les documents JP8032124 et US 6759587 décrivent des matériaux composites comprenant une matrice polymère et des charges thermoélectriques p ou n dispersées dans ladite matrice. Cependant dans ces documents, afin d'améliorer les propriétés thermoélectriques, le matériau subit un traitement thermique dans lequel la matrice polymère est soit retirée, soit dégradée altérant ainsi les propriétés mécaniques (souplesse, flexibilité...) mais conduisant également à des procédés plus coûteux (mise en forme complexe) et moins respectueux de l'environnement (solvants). Dans les documents précités, le polymère et/ou le solvant ne jouent pas un rôle de mise en forme et tous les traitements dégradent le matériau et altèrent ses propriétés de transport.

Il existe donc un réel besoin en une structure thermoélectrique de dimension métrique, à la fois performante (c'est-à-dire présentant de bonnes propriétés thermoélectriques), de faible densité de puissance et dotée de bonnes propriétés mécaniques lui conférant ainsi une bonne aptitude à la mise en forme en vue d'une intégration dans les bâtiments pour des applications de chauffage et de rafraichissement.

Or, la Demanderesse a découvert qu'une structure thermoélectrique comprenant une âme thermoélectrique d'une architecture spécifique et composée d'un matériau thermoélectrique hybride composite permettait de répondre à ces exigences.

Ainsi, un objet de l'invention est une âme thermoélectrique comprenant une jonction thermoélectrique consistant en une succession d'un élément conducteur, d'une bande d'élément semi-conducteur de type p de longueur $L_p$, d'épaisseur $e_p$ et de largeur lp, d'un élément conducteur, d'une bande d'élément semi-conducteur de type n de longueur $L_n$, d'épaisseur $e_n$ et de largeur $l_n$ et d'un élément conducteur ; et éventuellement en une succession de bandes d'éléments semi-conducteurs de type $p_i$ et de bandes d'éléments semi-conducteurs de type $n_j$ ;

- les bandes d'éléments semi-conducteurs composant l'âme thermoélectrique se succédant de telle façon que l'alternance semi-conducteur de type p-semi-conducteur de type n soit assurée ;
- les bandes d'éléments semi-conducteurs de type $p_i$ et $n_j$ étant séparées par un élément conducteur ;
- la première et la dernière bande de l'âme thermoélectrique étant des éléments conducteurs ;
- chaque bande d'élément semi-conducteur de type $p_i$ ayant indépendamment des autres une longueur $L_{pi}$, une épaisseur $e_{pi}$ et une largeur $l_{pi}$ et que chaque bande d'élément semi-conducteur de type $n_j$ ayant indépendamment des autres une longueur $L_{nj}$, une épaisseur $e_{nj}$ et une largeur $l_{nj}$ ;
- lesdites bandes d'éléments semi-conducteurs de type p, n, $p_i$ et $n_j$ étant jointes aux éléments conducteurs uniquement le long de leur largeur $l_p$, $l_n$, $l_{pi}$ ou $l_{nj}$ ;

avec

$$l_p > L_p \quad ; \quad l_n > L_n$$

$$L_p/e_p \geq 1 \quad ; \quad L_n/e_n \geq 1 \quad ;$$

$$l_{pi} > L_{pi} \quad ; \quad l_{nj} > L_{nj}$$

$$L_{pi}/e_{pi} \geq 1 \quad ; \quad L_{nj}/e_{nj} \geq 1$$

i allant de 0 à n et j allant de 0 à m, avec $n+m \geq 1$ ; n et m étant des nombres entiers, caractérisée par le fait que les bandes d'éléments semi-conducteurs de type p et éventuellement $p_i$ et/ou les bandes d'éléments semi-conducteurs de type n et éventuellement $n_j$ sont réalisées avec un matériau composite hybride thermoélectrique comprenant :

- une matrice polymère ;
- des charges thermoélectriques sous forme de particules dispersées au sein de la matrice polymère ;

les charges thermoélectriques étant des alliages multicomposants semi-conducteurs de type p ou de type n comprenant au moins les éléments Bi et Te.

Selon l'invention, le terme « jointes » désigne le fait qu'un élément conducteur et une bande d'élément semi-conducteur de type p, $p_i$, n ou $n_j$ sont en contact sur au moins une partie de leur largeur soit en étant accolées les unes par rapport aux autres ou en étant imbriquées les unes dans les autres.

Par matériau composite, on entend un matériau comprenant au moins deux matériaux non miscibles tels que la matrice polymère et les charges thermoélectriques.

Par matériau hybride, on entend un matériau qui comprend à la fois au moins un composé organique (matrice polymère) et au moins un composé inorganique (charges thermoélectriques). Ainsi, selon l'invention, la matrice polymère reste organique et n'est pas dégradée, conférant ainsi une bonne tenue thermomécanique à l'âme thermoélectrique de la présente invention.

Selon un mode de réalisation particulier, la matrice polymère est un polymère thermoformable.

Selon un autre mode de réalisation particulier pouvant être combiné au précédent, les alliages multicomposants semi-conducteurs de type p sont des alliages de $Bi_8Sb_{32}Te_{60}$ et les alliages multicomposants semi-conducteurs de type n sont des alliages de $Bi_{40}Te_{42}Se_{18}$ ou $Bi_{40}Te_{57}Se_3$.

Selon un mode de réalisation, les bandes d'éléments semi-conducteurs p et n sont réalisées à partir du matériau composite hybride décrit dans la demande de brevet FR 11 60289, déposée le 10 novembre 2011 au nom de la Demanderesse, qui est incorporée par référence, c'est-à-dire un matériau composite hybridecomprenant :

- une matrice polymère ;
- des charges thermoélectriques sous forme de particules dispersées au sein de la matrice polymère ;

dans lequel ledit matériau composite hybride est dépourvu de particules métalliques et les charges thermoélectriques sont des alliages multicomposants semi-conducteurs de type p ou de type n comprenant au moins les éléments Bi et Te.

Selon l'invention, les bandes d'éléments semi-conducteurs de type p et éventuellement $p_i$ ou de type n et éventuellement $n_j$ sont réalisées avec le matériau thermoélectrique composite hybride décrit précédemment présentant une figure de mérite élevée, de préférence supérieure à 0,1.

Ainsi, lorsque les bandes de semi-conducteurs sont réalisées avec les matériaux précités, lesdites bandes présentent non seulement de bonnes propriétés thermoélectriques mais également de très bonnes propriétés de souplesse et de flexibilité leur permettant d'être facilement intégrées dans des structures thermoélectriques de grande taille.

Ainsi, selon un mode de réalisation préféré, le rapport largeur sur longueur des bandes d'éléments semi-conducteurs p et éventuellement $p_i$ et des bandes d'éléments semi-conducteurs n et éventuellement $n_j$ est tel que $l_p > 10L_p$; $l_n > 10L_n$ ; $l_{pi} > 10L_{pi}$ et $l_{nj} > 10L_{nj}$, de préférence $l_p > 50L_p$ ; $l_n > 50L_n$ ; $l_{pi} > 50L_{pi}$ et $l_{nj} > 50L_{nj}$ et encore plus préférentiellement $l_p > 100L_p$ ; $l_n > 100L_n$ ; $l_{pi} > 100L_{pi}$ et $l_{nj} > 100L_{nj}$.

Selon encore un autre mode de réalisation pouvant être combiné au précédent, le rapport entre la longueur et l'épaisseur des bandes d'éléments semi-conducteurs p et éventuellement $p_i$ et des bandes d'éléments semi-conducteurs n et éventuellement $n_j$ est tel que $L_p/e_p \geq 1$ ; $L_n/e_n \geq 1$ ; $L_{pi}/e_{pi} \geq 1$ et $L_{nj}/e_{nj} \geq 1$ ; de préférence $L_p/e_p \geq 100$ ; $L_n/e_n \geq 100$ ; $L_p/e_{pi} \geq 100$ et $L_{nj}/e_{nj} \geq 100$.

Selon un autre mode de réalisation particulier, la largeur des bandes d'éléments semi-conducteurs $l_p$, $l_n$, $l_{pi}$ et $l_{nj}$, sont identiques et/ou la longueur des bandes d'éléments semi-conducteurs $L_p$, $L_n$, $L_{pi}$ et $L_{nj}$, sont identiques et/ou l'épaisseur des bandes d'éléments semi-conducteurs $e_p$, $e_n$, $e_{pi}$ ete$_{nj}$ sont identiques.

Selon un autre mode de réalisation particulier, l'élément conducteur se présente sous la forme d'une bande présentant une épaisseur, une largeur et une longueur sensiblement égale à celle des bandes d'éléments semi-conducteurs de type p et éventuellement $p_i$ et/ou à la bande d'élément semi-conducteur de type n et éventuellement $n_j$.

Selon l'invention, l'élément conducteur présente de bonnes propriétés de conduction thermique et électrique.

On peut citer à titre d'exemple, des éléments conducteurs en cuivre, en or ou en aluminium.

Selon un mode de réalisation préféré de l'invention, l'élément conducteur est en cuivre.

Un autre objet de l'invention concerne une structure thermoélectrique comprenant au moins une âme thermoélectrique telle que définie précédemment, caractérisée par le fait que chaque élément conducteur successif est en contact respectivement avec un potentiel thermique à une température T1 et un potentiel thermique à une température T2, avec T1>T2.

Selon un mode de réalisation, la structure thermoélectrique comprend au moins une paroi supérieure présentant un potentiel thermique à la température T1 ayant une surface inférieure et une surface supérieure et au moins une paroi inférieure présentant un potentiel thermique à la température T2 ayant une surface inférieure et une surface supérieure, caractérisée par le fait que l'âme thermoélectrique est disposée entre lesdites parois supérieure et inférieure, de telle façon que chaque élément conducteur successif est en contact respectivement avec la surface inférieure de la paroi supérieure et avec la surface supérieure de la paroi inférieure.

Selon un mode de réalisation particulier, au moins une partie de chaque élément conducteur successif est en contact respectivement avec la surface inférieure de la paroi supérieure et avec la surface supérieure de la paroi inférieure.

Selon un autre mode de réalisation, l'âme thermoélectrique est disposée entre les deux parois inférieure et supérieure de telle façon que :

- l'angle interne $\alpha_{(ps)}$ entre un élément conducteur en contact avec la surface inférieure de la paroi supérieure et une bande adjacente d'élément semi-conducteur de type p et l'angle alterne $\alpha_{(pi)}$ entre un élément conducteur successif en contact avec la surface supérieure de la paroi inférieure et la même bande adjacente d'élément semi-conducteur de type p sont identiques et appelés angle $\alpha$ ; et éventuellement l'angle interne $\alpha i_{(ps)}$ entre un élément conducteur en contact avec la surface inférieure de la paroi supérieure et une bande adjacente d'élément semi-conducteur de type $p_i$ et l'angle alterne $\alpha i_{(pi)}$ entre un élément conducteur successif en contact avec la surface supérieure de la paroi inférieure et la même bande adjacente d'élément semi-conducteur de type $p_i$ sont identiques et appelés angle

$\alpha$i ; et

- que l'angle interne $\beta_{(ps)}$ entre un élément conducteur en contact avec la surface inférieure de la paroi supérieure et une bande adjacente d'élément semi-conducteur de type n et l'angle alterne $\beta_{(pi)}$ entre un élément conducteur successif est en contact avec la surface supérieure de la paroi inférieure et la même bande adjacente d'élément semi-conducteur de type n sont identiques et appelés angle $\beta$ ; et éventuellement l'angle interne $\beta_{j(ps)}$ entre un élément conducteur en contact avec la surface inférieure de la paroi supérieure et une bande adjacente d'élément semi-conducteur de type $n_j$ et l'angle alterne $\beta_{j(pi)}$ entre un élément conducteur successif en contact avec la surface supérieure de la paroi inférieure et la même bande adjacente d'élément semi-conducteur de type $n_j$ sont identiques et appelés angle $\beta_j$;

avec $0°<\alpha<180°$ ; $0°<\beta<180°$ et éventuellement $0°<\alpha_i<180°$ ; $0°< \beta_j<180°$ ;

i allant de 0 à n et j allant de 0 à m, avec $n+m\geq 1$ ; n et m étant des nombres entiers.

Selon un mode de réalisation, les angles $\alpha$, $\beta$, $\alpha_i$ et $\beta_j$ sont égaux à 90°. Dans cette configuration, la structure thermoélectrique présente une bonne tenue mécanique.

Selon un mode de réalisation, les angles $\alpha$, $\beta$, $\alpha_i$ et $\beta_j$ sont supérieurs à 90°. Dans cette configuration, la structure thermoélectrique présente une surface d'échange optimisée.

Selon un autre mode de réalisation, la structure thermoélectrique comprend une paroi supérieure présentant un potentiel thermique à une température T1 ayant une surface inférieure et surface supérieure, une paroi inférieure présentant également un potentiel thermique à une température T1 ayant une surface inférieure et surface supérieure et une paroi intermédiaire présentant un potentiel thermique à une température T2 disposée entre les parois supérieure et inférieure, avec T1>T2, caractérisée par le fait que l'âme thermoélectrique est disposée entre lesdites parois supérieure et inférieure, de telle façon que chaque élément conducteur successif est en contact respectivement avec la surface inférieure de la paroi supérieure, la paroi intermédiaire et la surface supérieure de la paroi inférieure.

Par la suite, par « parois », il est fait référence à la paroi supérieure et/ou paroi inférieure et/ou paroi intermédiaire.

Afin d'augmenter sa tenue mécanique, la structure thermoélectrique peut comprendre en outre des bandes d'éléments supports accolées sur une face ou les deux faces des bandes d'éléments semi-conducteurs de type p et éventuellement $p_i$ et/ou de type n et éventuellement $n_j$ et/ou les éléments conducteurs de telle façon que lorsqu'une face d'un élément conducteur est accolée à une paroi, les dites bandes d'élément support se trouve sur l'autre face dudit élément conducteur.

Les bandes d'élément support sont réalisées en un matériau choisi dans le groupe comprenant le kapton, le bois, le carton, les minéraux tels que la cordiérite, la fibre de verre, ou un polymère thermoformable.

Selon un mode de réalisation préféré, les bandes d'élément support sont réalisées en pressant à chaud sous vide.

Selon un mode de réalisation, les bandes d'éléments support présentent la même conformation que la bande d'élément semi-conducteurs de type p et éventuellement $p_i$ et/ou de type n et éventuellement $n_j$.

Par « conformation », on entend les 3 dimensions que sont la largeur, la longueur et l'épaisseur des bandes d'éléments semi-conducteurs.

Selon l'invention, les parois sont thermiquement conductrices.

A titre d'exemple, on peut citer des parois en cuivre ou aluminium.

Selon l'invention, les parois conductrices thermiquement sont isolées électriquement des éléments conducteurs.

A titre d'exemple, la paroi peut être recouverte d'un époxy pour éviter un court-circuit avec les éléments conducteurs. Selon l'invention, les parois peuvent être planes et/ou courbes.

Selon un mode de réalisation de l'invention, les parois supérieure et inférieure sont des parois planes et parallèles entre elles.

Selon un autre mode de réalisation, les parois parallèles peuvent former une géométrie courbe.

Selon encore un autre mode de réalisation, lorsque la structure comprend en outre des parois intermédiaires, ces dernières sont cylindriques.

Selon un mode de réalisation, la structure thermoélectrique est alimentée électriquement.

L'âme thermoélectrique peut être alimentée électriquement au niveau des éléments conducteurs qui se trouvent aux deux extrémités opposées de l'âme thermoélectrique.

Selon un mode de réalisation, l'alimentation électrique est un courant continu.

Le flux de courant traverse les bandes d'éléments semi-conducteurs le long de leur longueur $L_p$, $L_n$, $L_{pi}$ et $L_{nj}$. Ainsi, lorsque le courant passe d'une bande p à une bande n via une bande conductrice, ladite bande conductrice se trouve à une température T1. Dans le même temps, lorsque le courant passe d'une bande n à une bande p via une autre bande conductrice, ladite autre bande conductrice se trouve à une température T2. On aboutit ainsi à une succession de bandes conductrices successivement à une température T1 puis à une température T2.

Selon l'invention, la densité de puissance thermique fournie par la structure thermoélectrique est inférieure à

6kW/m$^2$, de préférence inférieure à 1 kW/m$^2$ et encore plus préférentiellement inférieure à 0.1kW/m$^2$.

Par « densité de puissance thermique », on entend le flux de chaleur fourni par la paroi de la structure thermoélectrique dont la température est la plus élevée.

Il existe une corrélation forte entre le dimensionnement des bandes (nombre et dimensionnel) et la densité de puissance thermique délivrée par la structure thermoélectrique.

Selon l'invention, le nombre de bandes d'éléments semi-conducteurs dans la structure thermoélectrique est fonction de divers paramètres tels que la densité de puissance souhaitée mais également de l'épaisseur et la longueur des bandes d'éléments semi-conducteurs.

Ainsi, l'homme du métier saura choisir la valeur de n+m en fonction de la surface de la structure thermoélectrique.

Par exemple, n+m est compris entre 2 et 1000 pour une surface de 1m$^2$.

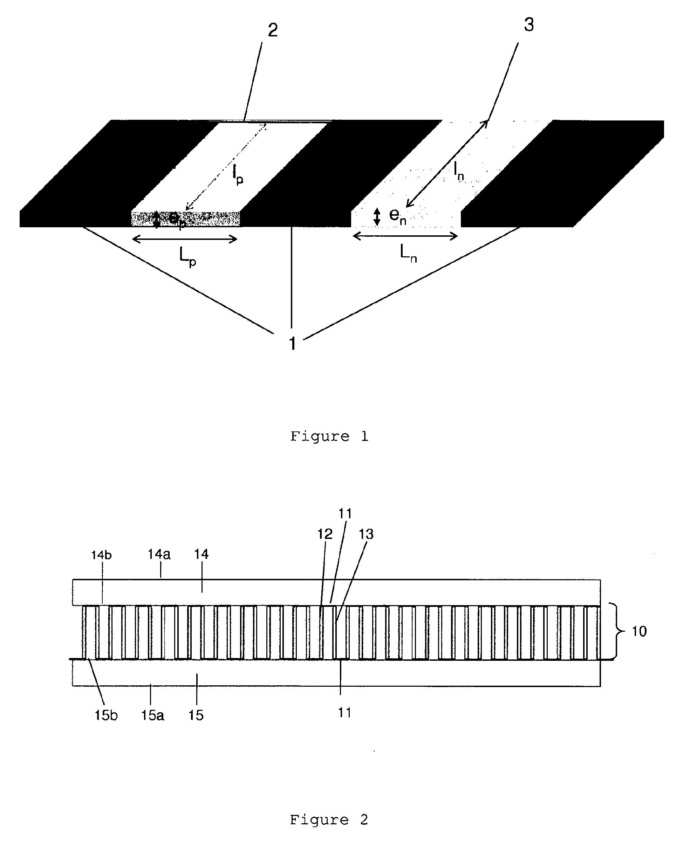

La figure 1 représente une âme thermoélectrique constituée d'une jonction thermoélectrique selon l'invention.

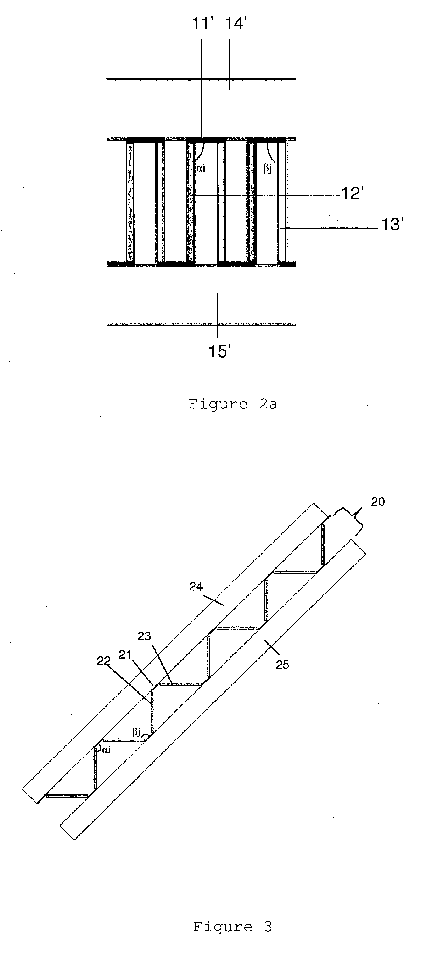

La figure 2 représente une structure thermoélectrique dans laquelle l'âme thermoélectrique est disposée entre deux parois planes et parallèles présentant respectivement un potentiel thermique à une température T1 et un potentiel thermique à une température T2 ; les angles $\alpha$, $\beta$, $\alpha_i$ et $\beta_j$ étant égaux à 90°.

La figure 2a est un agrandissement de la figure 2.

La figure 3 représente une structure thermoélectrique dans laquelle l'âme thermoélectrique est disposée entre deux parois planes et parallèles présentant respectivement un potentiel thermique à une température T1 et un potentiel thermique à une température T2 ; les angles $\alpha$, $\beta$, $\alpha_i$ et $\beta_j$ étant des angles ouverts.

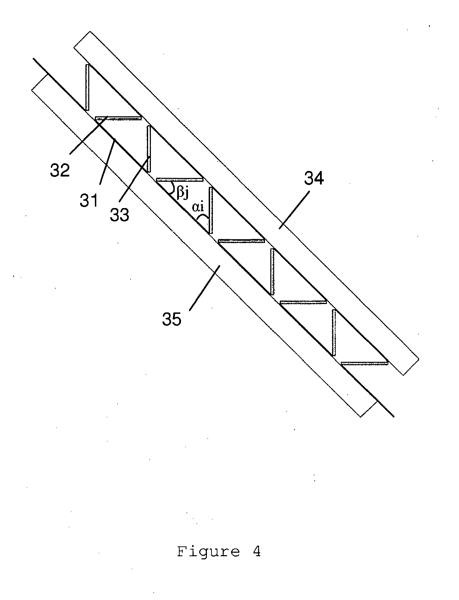

La figure 4 représente une structure thermoélectrique dans laquelle l'âme thermoélectrique est disposée entre deux parois planes et parallèles présentant respectivement un potentiel à une température T1 et un potentiel à une température T2 ; les angles $\alpha$, $\beta$, $\alpha_i$ et $\beta_j$ étant des angles fermés.

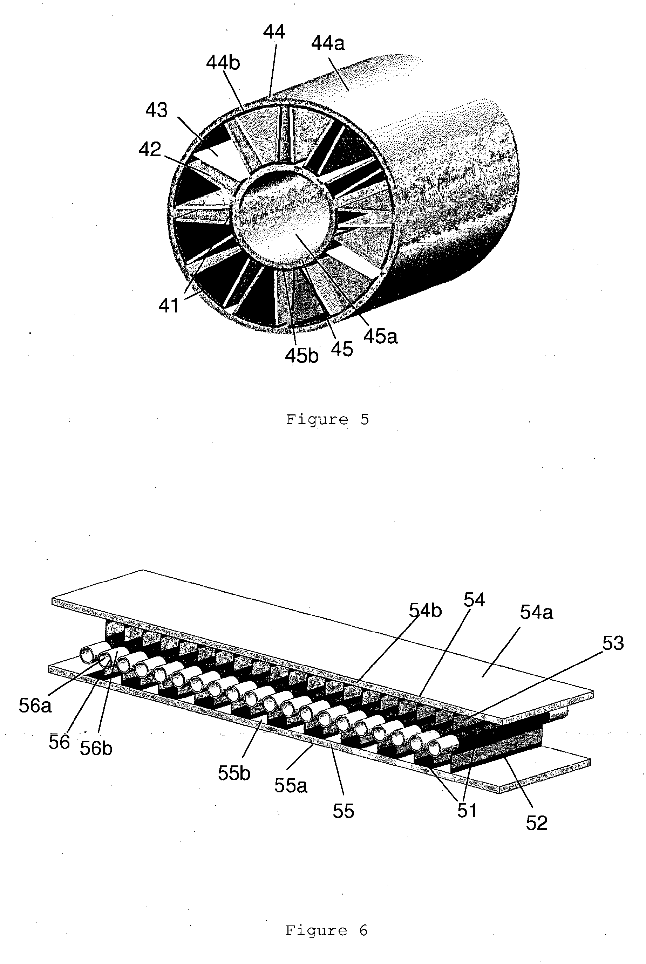

La figure 5 représente une structure thermoélectrique dans laquelle l'âme thermoélectrique est pliée entre deux parois cylindriques et concentriques présentant respectivement un potentiel à une température T1 et un potentiel à une température T2 ; les angles $\alpha$, $\beta$, $\alpha_i$ et $\beta_j$ étant des angles fermés.

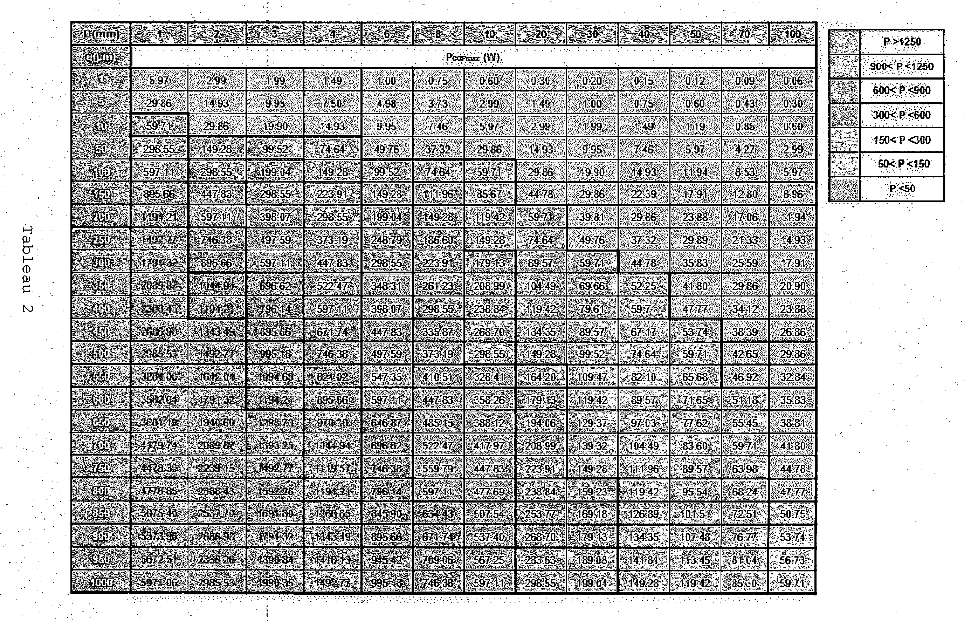

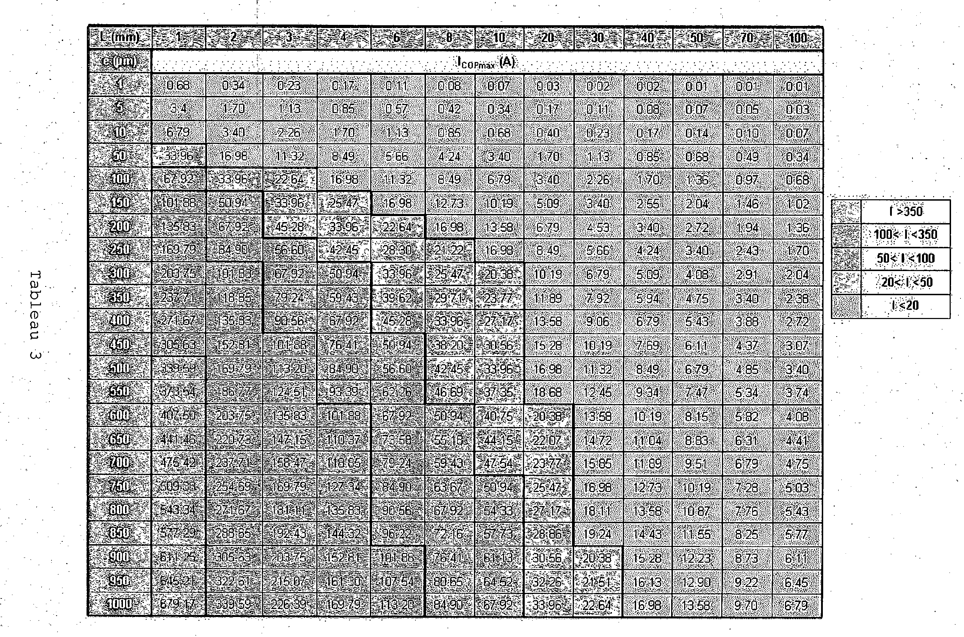

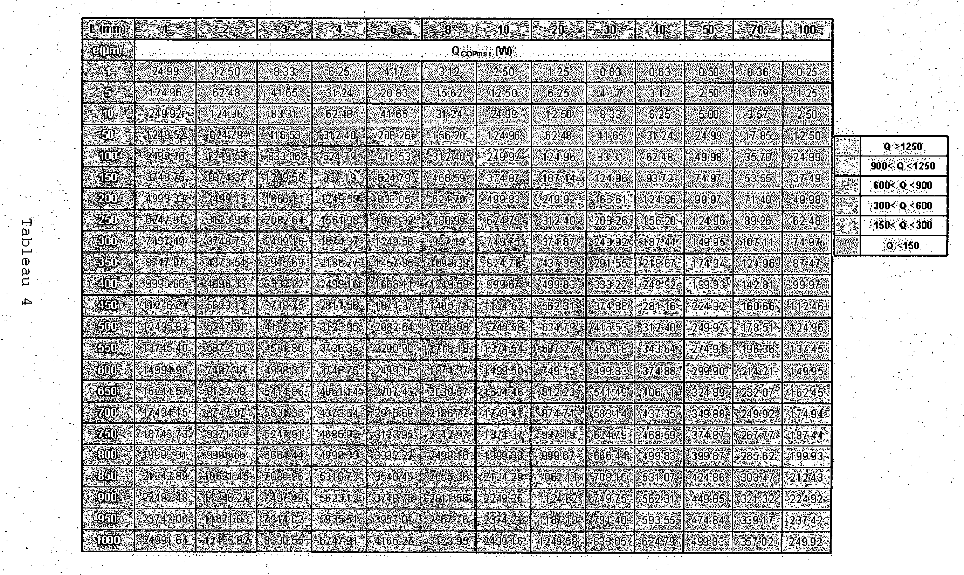

La figure 6 représente une structure thermoélectrique comprenant une âme thermoélectrique, deux parois à un potentiel thermique T1 et des parois intermédiaires à un potentiel thermique T2, ladite âme thermoélectrique étant agencée entre les deux parois au potentiel thermique T1.

Dans toutes les figures décrites ci-dessous, les éléments semi-conducteurs de type p (ou $p_i$) et n (ou $n_j$) sont réalisés avec le matériau thermoélectrique composite hybride décrit précédemment, c'est-à-dire comprenant :

- une matrice polymère ;
- des charges thermoélectriques sous forme de particules dispersées au sein de la matrice polymère ;
- les charges thermoélectriques étant des alliages multicomposants semi-conducteurs de type p (pour les éléments semi-conducteurs de type p (ou $p_i$)) ou de type n (pour les éléments semi-conducteurs de type n (ou $n_j$)) comprenant au moins les éléments Bi et Te.

La figure 1 représente une âme thermoélectrique comprenant une jonction thermoélectrique. La jonction thermoélectrique est constituée d'un élément conducteur 1, une bande d'un élément semi-conducteur de type p 2, un élément conducteur 1, une bande d'un élément semi-conducteur de type n 3, et un élément conducteur 1, les éléments conducteurs et les bandes d'éléments semi-conducteurs étant accolés les uns aux autres. Sur la figure 1, les bandes d'éléments semi-conducteurs présentent la même largeur, la même longueur et la même épaisseur, en d'autres mots ln=lp ;Ln=Lp et ep=en. Les éléments conducteurs 1 se trouvent sous la forme de bandes qui présentent les même dimensions (largeur, longueur et épaisseur) que les bandes d'éléments semi-conducteurs de type p 2 ou n 3 et sont accolées auxdites bandes d'éléments de semi-conducteurs de type p ou n selon toute la largeur $l_n$ (donc $l_p$).

La figure 2 représente une structure thermoélectrique comprenant une âme thermoélectrique 10 constituée d'une jonction thermoélectrique et d'une succession de bandes d'éléments semi-conducteurs de type $p_i$ et de bandes d'éléments semi-conducteurs de type $n_j$ séparées les unes des autres par des bandes d'éléments conducteurs. La structure thermoélectrique de la figure 2 comprend une paroi supérieure 14 (présentant un potentiel thermique à la température T1 non représenté sur la figure) avec une surface supérieure 14a et une surface inférieure 14b et une paroi inférieure 15 (présentant un potentiel thermique à la température T2 non représenté sur la figure) avec une surface supérieure 15b et une surface inférieure 15a. Les parois (14;15) sont planes et parallèles entre elles.

L'âme thermoélectrique 10 est disposée entre les parois (14;15) sous une forme rectangulaire de telle façon que :

- une bande d'élément conducteur 11 est accolée à la surface inférieure 14b de la paroi supérieure 14 et que la bande d'élément conducteur suivante 11 est accolée à la surface supérieure 15b de la paroi inférieure 15 ; et
- l'angle formé entre chaque bande d'élément conducteur 11 et chaque bande adjacente d'élément semi-conducteur de type p ou p$_i$ 12 et l'angle formé entre chaque bande d'élément conducteur 11 et chaque bande adjacente d'élément semi-conducteur de type n ou n$_j$13 sont égaux.

La figure 2a est un agrandissement de la figure 2 mettant en évidence que l'angle $\alpha_i$ entre une bande d'élément conducteur 11' et une bande d'élément semi-conducteur de type p$_i$ 12' est égal à 90° et que l'angle $\beta_j$ entre une bande d'élément conducteur 11' et une bande d'élément semi-conducteur de type n$_j$13' est aussi égal à 90°.

Les figures 3 et 4 représentent une structure similaire à la structure thermoélectrique des figures 2 et 2a décrite précédemment à la différence que dans la figure 3, l'angle $\alpha$ entre un élément conducteur 21 et une bande adjacente d'élément semi-conducteur de type p, l'angle $\alpha_i$ entre un élément conducteur 21 et une bande adjacente d'élément semi-conducteur de type p$_i$ 22, l'angle $\beta$ entre un élément conducteur 21 et une bande adjacente d'élément semi-conducteur de type n et l'angle $\beta j$ entre un élément conducteur 21 et une bande adjacente d'élément semi-conducteur de type n$_j$23 sont des angles ouverts (c'est-à-dire supérieur à 90°) et que dans la figure 4, l'angle $\alpha$ entre un élément conducteur 31 et une bande adjacente d'élément semi-conducteur de type p 32, l' angle $\alpha_i$ entre un élément conducteur 31 et une bande adjacente d'élément semi-conducteur de type p$_i$ 32, l'angle $\beta$ entre un élément conducteur 31 et une bande adjacente d'élément semi-conducteur de type n 33 et l'angle $\beta_j$ entre un élément conducteur 31 et une bande adjacente d'élément semi-conducteur de type n$_j$ 33 sont des angles fermés (c'est-à-dire inférieurs à 90°).

La figure 5 représente une structure thermoélectrique comprenant une âme thermoélectrique selon un mode de réalisation de l'invention. Ladite âme thermoélectrique est disposée sous forme trapézoïdale entre une paroi supérieure cylindrique 44 ayant une surface supérieure 44a et une surface inférieure 44b (présentant un potentiel thermique à la température T1 non représenté sur la figure) et une paroi inférieure cylindrique 45 ayant une surface supérieure 45a et une surface inférieure 45b (présentant un potentiel thermique à une température T2 non représenté sur la figure) de telle façon qu'une bande d'élément conducteur 41 est en contact avec la surface inférieure 44b de la paroi supérieur et qu'une bande d'élément conducteur suivante 41 est en contact avec la surface supérieure 45b de la paroi inférieure.

La figure 6 représente une structure thermoélectrique comprenant une âme thermoélectrique selon un autre mode de réalisation de l'invention. Ladite structure thermoélectrique présente une paroi supérieure 54 ayant une surface supérieure 54a et une surface inférieure 54b et une paroi inférieure 55 ayant une surface supérieure 55a et une surface inférieure 55b ; lesdites parois supérieure et inférieure présentant un potentiel à une température T1. La structure thermoélectrique de la figure 6 comporte également des parois intermédiaires 56 ayant une surface inférieure 56a et une surface supérieure 56b et qui présentent un potentiel thermique à une température T2. Les parois supérieure et inférieure (54 ;55) sont planes et parallèles entre elles et les parois intermédiaires qui sont disposées entre les parois inférieure et supérieure sont cylindriques.

L'âme thermoélectrique est pliée de telle façon que de manière successive un premier élément conducteur 51 est en contact avec la surface inférieure 54b de la paroi supérieure 54, un second élément conducteur 51 est en contact avec la surface supérieure 56b de la paroi intermédiaire 56 et un troisième élément conducteur 51 est en contact avec la surface supérieure 55b de la paroi inférieure 55.

Un autre objet de l'invention concerne un procédé de réalisation d'une structure thermoélectrique comprenant une paroi supérieure présentant un potentiel thermique à une température T1 et une autre paroi inférieure présentant un potentiel thermique à une température T2 telle que définie précédemment comprenant les étapes suivantes :

(i) réaliser au moins une jonction thermoélectrique ;
(ii) éventuellement joindre des bandes successives d'éléments semi-conducteurs de type p$_i$ et des bandes successives d'éléments semi-conducteurs de type n$_j$ séparées les unes des autres par un élément conducteur pour former l'âme thermoélectrique;
(iii) mettre en forme la dite âme thermoélectrique;
(iv) fixer la dite âme thermoélectrique entre une paroi supérieure ayant une surface inférieure et une surface supérieure et au moins une paroi inférieure ayant une surface inférieure et une surface supérieure de façon à ce que chaque élément conducteur successif soit collé respectivement à la surface inférieure de la paroi supérieure et à la surface supérieure de la paroi inférieure.

Un autre objet de l'invention concerne un procédé de réalisation d'une structure thermoélectrique comprenant deux parois au potentiel thermique à une température T1 et une autre paroi au potentiel thermique à une température T2 comprenant les étapes suivantes :

(i) réaliser au moins une jonction thermoélectrique ;
(ii) éventuellement joindre des bandes successives d'éléments semi-conducteurs de type p$_i$ et des bandes successives d'éléments semi-conducteurs de type n$_j$ séparées les unes des autres par un élément conducteur pour former l'âme thermoélectrique;
(iii) mettre en forme la dite âme thermoélectrique;

(iv) fixer la dite âme thermoélectrique entre une paroi supérieure ayant une surface inférieure et une surface supérieure et au moins une paroi inférieure ayant une surface inférieure et une surface supérieure et au moins une paroi intermédiaire de façon à ce que chaque élément conducteur successif soit collé respectivement à la surface inférieure de la paroi supérieure, à la paroi intermédiaire et à la surface supérieure de la paroi inférieure.

La réalisation de l'âme thermoélectrique peut être réalisée par diverses techniques telles que l'extrusion, le pressage à chaud, le thermo-laquage ou le thermo-soudage.

Selon un mode de réalisation préféré, l'âme thermoélectrique est réalisée par pressage à chaud et comprend les étapes suivantes :

(i) placer dans une matrice de pressage présentant différents compartiments ayant une longueur, une largeur et une épaisseur donnée un élément conducteur dans un premier compartiment, un élément semi-conducteur de type p correspondant au matériau thermoélectrique composite hybride tel que décrit dans l'invention comprenant des alliages multicomposants semi-conducteurs de type p dans un second compartiment, un élément conducteur dans un troisième compartiment, un élément semi-conducteur de type n correspondant au matériau thermoélectrique composite hybride tel que décrit dans l'invention comprenant des alliages multicomposants semi-conducteurs de type n dans un quatrième compartiment et un élément conducteur dans un cinquième compartiment; et éventuellement une succession de bandes d'éléments semi-conducteurs de type $p_i$ et de type correspondant aux matériaux thermoélectriques composites hybrides tels que décrits dans l'invention comprenant des alliages multicomposants semi-conducteurs de type p (pour des bandes d'éléments semi-conducteurs de type $p_i$) ou n (pour des bandes d'éléments semi-conducteurs de type $n_j$) avec des éléments conducteurs intercalés entre lesdites bandes dans d'autres compartiments ;
(ii) mettre en montée en température la matrice de pressage pour atteindre une température TEMP1;
(iii) augmenter la pression P dans la matrice de pressage ;
(iv) maintenir la température TEMP1 et la pression P pendant une durée t ;
(v) descendre en température à une température TEMP2 en maintenant la pression P ;
(vi) diminuer la pression jusqu'à la pression atmosphérique ;
(vii) démouler la matrice de pressage.

Après le démoulage de la matrice de pressage, l'âme thermoélectrique se trouve sous la forme d'une succession de bandes accolées les unes aux autres ou imbriquées les unes dans les autres.

Lorsque les bandes sont imbriquées les unes dans les autres, la résistance mécanique de la jonction entre l'élément conducteur et la bande de matériau semi-conducteur de type p ou n est améliorée et la résistance électrique de contact entre ces deux matériaux de nature différente est réduite.

Selon un mode de réalisation préféré, les éléments conducteurs sont directement introduits dans la matrice de pressage sous forme de bandes solides.

Selon l'invention, les éléments semi-conducteurs de type p et éventuellement $p_i$ ou n et éventuellement $n_j$ sont introduits dans la matrice de pressage sous forme liquide ou sous forme de poudre.

Selon un mode de réalisation préféré, les éléments semi-conducteurs de type p et éventuellement $p_i$ ou n et éventuellement $n_j$ sont introduits dans la matrice de pressage sous forme de poudre.

Selon l'invention, l'élément semi-conducteur de type p et éventuellement $p_i$ est constitué d'une matrice polymère et de charges thermoélectriques de type p comprenant au moins les éléments Bi et Te sous forme de particules dispersées au sein de la matrice polymère et l'élément semi-conducteur de type n et éventuellement $n_j$ est constitué d'une matrice polymère et de charges thermoélectriques de type n comprenant au moins les éléments Bi et Te sous forme de particules dispersées au sein de la matrice polymère.

Ainsi, selon un mode de réalisation particulier, les éléments semi-conducteurs de type n et p sont introduits dans la matrice de pressage sous la forme d'un mélange de charges thermoélectriques comprenant des alliages multicomposants semi-conducteurs de type n (pour les éléments semi-conducteurs de type n) ou de type p (pour les éléments semi-conducteurs de type p) comprenant au moins les éléments Bi et Te ; lesdites charges thermoélectriques étant dispersées dans un polymère ou un copolymère.

Selon un mode de réalisation, le polymère est choisi dans le groupe comprenant le polystyrène (PS), le polychlorure de vinyle (PVC), la polyaniline (PA), le polyéthylène (PE), le polyfluorure de vinylidène (PVDF), le poly(méthyl méthacrylate) (PMMA), le poly vinyl acétate (PVA), le polyimide (PI), le polypropylène (PP) et leurs mélanges.

Selon un autre mode de réalisation, la matrice polymère est un co-polymère afin d'augmenter les propriétés mécaniques du matériau composite. A titre d'exemple de co-polymère, on peut citer le polyéthylène (PE)/ poly(méthyl méthacrylate)(PMMA), le polyéthylène (PE)/ poly vinyl acétate (PVA) ou le polystyrène (PS)/ polypropylène (PP), et leurs mélanges.

Selon un autre mode de réalisation, la matrice polymère est composée d'au moins un polymère et au moins un copolymère tels que décrits précédemment.

Selon un autre mode de réalisation préféré, les charges thermoélectriques de type p sont des alliages de $Bi_8Sb_{32}Te_{60}$ et les charges thermoélectriques de type n sont des alliages de $Bi_{40}Te_{42}Se_{18}$ou $Bi_{40}Te_{57}Se_3$.

Selon l'invention, la température TEMP1 est comprise entre 50°C et 300°C, de préférence entre 100°C et 200°Cet est nécessairement supérieure à la température de transition vitreuse de la matrice polymère et inférieure à la température de dégradation de la matrice polymère afin d'obtenir un matériau thermoélectrique hybride. En effet, le fait que la matrice polymère reste organique après la mise en forme permet de conférer de bonnes propriétés mécaniques à l'âme thermoélectrique.

La montée en température peut être contrôlée par un régulateur.La rampe de température peut être comprise entre 1°C/min et 100°C/min, de préférence entre 5°C/min et 50°C/min, et encore plus préférentiellement entre 5°C/min et 15°C/min.

Selon un mode de réalisation, la pression P est comprise entre 10MPa et 1GPa, de préférence entre 100MPa et 500 MPaet encore plus préférentiellement entre 200MPa et 400 MPa.

Selon l'invention, la pression P et la température TEMP1 sont maintenues pendant une durée t comprise entre 1 minute et 1 heure, de préférence entre 5 minutes et 1 heure, et encore plus préférentiellement entre 30 minutes et 1 heure.

La descente en température peut être réalisée avec ou sans contrôle extérieur, c'est-à-dire soit en imposant une rampe de refroidissement soit en laissant la matrice de pressage se refroidir naturellement jusqu'à atteindre TEMP2 qui se situe autour de la température ambiante.

Par température ambiante, on entend une température comprise entre 20°C et 25°C.

Selon un mode de réalisation particulier, au moins une bande d'élément support est déposée dans au moins un des compartiments avant et/ou après le dépôt de l'élément conducteur et/ou de l'élément semi-conducteur de type p et éventuellement $p_i$ et/ou de l'élément semi-conducteur de type n et éventuellement $n_j$.

Lorsque la mise en forme de l'âme thermoélectrique est réalisée par pressage à chaud, il y a création d'un réseau percolant dans lequel les particules de charges thermoélectriques de type p ou de type n sont accolées les unes aux autres permettant ainsi d'améliorer les propriétés de conductivité électrique. L'amélioration de la conductivité électrique est un élément capital car ce paramètre améliore les valeurs du facteur de mérite (ZT). En effet, le phénomène de percolation permet d'améliorer les valeurs du facteur de mérite et de contrebalancer la baisse de ces mêmes valeurs de facteur de mérite (conductivité notamment) due à l'introduction du polymère (nécessaire pour conférer une bonne tenue thermomécanique).

Selon un mode de réalisation particulier, un ensemble de bandes réalisé par exemple par pressage à chaud peut être accolée à un autre ensemble réalisé par pressage à chaud par diverses méthodes telles que la soudure afin de former l'âme thermoélectrique.

Selon l'invention, la mise en forme de l'âme thermoélectrique peut être réalisée par différentes techniques telle que le thermoformage ou le pressage à chaud.

Selon un mode de réalisation préféré de l'invention, la mise en forme de l'âme thermoélectrique est réalisée par thermoformage et comprend les étapes suivantes :

- placer un moule correspondant à la géométrie désirée, en fonction des angles $\alpha$, $\beta$, $\alpha i$ et $\beta j$ fixés, sur un plateau porte moule ;
- fixer l'âme thermoélectrique à un cadre situé bien au-dessus du moule;
- chauffer l'âme thermoélectrique afin de lui donner la plasticité nécessaire ;
- arrêter le chauffage une fois la plasticité requise ;
- relever le moule grâce au plateau porte-moule et le placer juste en dessous de l'âme thermoélectrique ;
- aspirer l'air résiduel entre le moule et l'âme thermoélectrique ;
- refroidir l'âme thermoélectrique et redescendre le moule à l'aide du plateau porte-moule.

Les dimensions spécifiques et l'agencement des différents éléments conducteurs et des bandes d'éléments semi-conducteurs p et éventuellement $p_i$ ou n et éventuellement $n_j$ de l'âme thermoélectrique permettent de réaliser une structure thermoélectrique de taille métrique.

Elle est ainsi parfaitement appropriée pour être utilisée dans des applications faisant appel aux effets Peltier ou Seebeck.

Ainsi un autre objet de l'invention concerne l'utilisation de la structure thermoélectrique décrit précédemment dans la réalisation de panneaux composites hybrides thermoélectriques de faible densité de puissance en vue d'applications en chauffage et rafraîchissement de bâtiments.

Un autre objet de l'invention est l'utilisation de la structure thermoélectrique en tant que paroi chauffante basse température et/ou rafraichissante ou en tant que radiateur actif chauffant basse température et/ou rafraichissant.

La présente invention est illustrée avec les exemples suivants.

[Exemples]

**Exemple 1 : Simulation du dimensionnement d'un panneau thermoélectrique selon l'invention en mode chauffage**

Le panneau thermoélectrique grande surface de l'invention est conçu pour des applications de chauffage basse température et/ou de rafraîchissement. La cible bâtiment pour ce type de système est notamment le BBC (bâtiment basse consommation).

Cet exemple met en évidence le dimensionnement d'un panneau thermoélectrique de faible puissance surfacique (typiquement quelques dizaines de watt par $m^2$ suffisent à chauffer ce type de bâtiment).

Un panneau thermoélectrique a donc été modélisé en disposant une âme thermoélectrique entre une paroi froide (à une température de 9°C) et une paroi chaude (à une température 19°C).

Les parois du panneau thermoélectrique sont planes et parallèles entre elles et sont réalisées en cuivre.

L'âme thermoélectrique est constituée de 500 bandes d'éléments semi-conducteurs de type p et $p_i$ et de 500 bandes d'éléments semi-conducteurs de type n et $n_j$, chacune des dites bandes étant séparées par des bandes d'éléments conducteurs.

L'âme thermoélectrique est disposée de telle façon que chaque bande d'élément conducteur successive est en contact respectivement avec la paroi chaude et avec la paroi froide.

Une telle structure est illustrée par la figure 4.

Les bandes d'éléments semi-conducteurs de type p, $p_i$ et de type n, ni ainsi que les bandes d'éléments conducteurs présentent une largeur identique qui est fixée à 1m.

Les bandes d'éléments semi-conducteurs de type p, $p_i$ et de type n, $n_j$ présentent une longueur identique et une épaisseur identique mais ces deux paramètres peuvent varier.

Le coefficient de Seebeck, la résistivité et la conductivité thermique des éléments semi-conducteurs sont également fixés (la figure de mérite ZT est de 0,7 à 300K).

Les paramètres non variables sont regroupés dans le tableau suivant :

Tableau 1

| | |
|---|---|
| Coefficient Seebeck des éléments semi-conducteurs de type p et n | 200 microV.K$^{-1}$ |
| Résistivité des éléments semi-conducteurs de type p,$p_i$ et n,$n_j$ | 0.001 ohm.cm |
| Conductivité thermique des éléments semi-conducteurs de type p,$p_i$ et n,$n_j$ | 0.017 W.cm$^{-1}$.K$^{-1}$ |
| T2 | 282.16K (9°C) |
| T1 | 292.16K (19°C) |
| Largeur des bandes d'éléments semi-conducteurs | 1m |
| Nombre de jambes (ou bandes) | 1000 |

Dans le cadre de cette modélisation, il a été déterminé pour chaque couple (épaisseur des bandes d'éléments semi-conducteurs type p,$p_i$ et n, $n_j$ longueur des bandes d'éléments semi-conducteurs type p,$p_i$ et n,$n_j$) une valeur de puissance électrique (tableau 2), de courant d'alimentation (tableau 3) et de puissance surfacique (tableau 4).

Comme exposé précédemment, le but de cet exemple est d'obtenir de faibles puissances surfaciques.

Le tableau 4 montre qu'il existe plusieurs configurations pour lesquelles il est possible d'obtenir ce niveau de puissance $Q_{COPmax} < 150$ W/m$^2$. Il est à noter que ces valeurs de puissance sont celles obtenues lorsque le panneau thermoélectrique est alimenté avec un courant électrique $I_{COPmax}$ permettant de maximiser la performance du panneau (COPmax). En effet, le tableau 3 indique la valeur du courant d'alimentation du panneau thermoélectrique qui est inférieur à 20A pour les configurations mentionnées ci-dessus. Enfin, le tableau 2 indique la puissance électrique nécessaire au bon fonctionnement du panneau thermoélectrique d'une surface de 1m$^2$ et de 1000 bandes semi-conductrices. Ainsi, la puissance électrique ne dépasse pas 50 W.

Cet exemple met donc en évidence que la structure thermoélectrique selon l'invention permet d'obtenir un panneau thermoélectrique de dimension métrique et performant.

**Revendications**

**1.** Ame thermoélectrique (10 ;20) comprenant une jonction thermoélectrique consistant en une succession d'un élément conducteur (1;11;21;31;41;51), d'une bande d'élément semi-conducteur de type p (2;12;22;32;42;52) de longueur $L_p$, d'épaisseur $e_p$ et de largeur lp, d'un élément conducteur (1;11;21;31;41;51), d'une bande d'élément semi-conducteur de type n (3;13;23;33;43;53) de longueur $L_n$, d'épaisseur en et de largeur $l_n$ et d'un élément conducteur (1;11;21;31;41;51) ; et éventuellement en une succession de bandes d'éléments semi-conducteurs de type $p_i$ et de bandes d'éléments semi-conducteurs de type $n_j$ ;

- les bandes d'éléments semi-conducteurs composant l'âme thermoélectrique se succédant de telle façon que l'alternance semi-conducteur de type p-semi-conducteur de type n soit assurée ;
- les bandes d'éléments semi-conducteurs de type $p_i$ et $n_j$ étant séparées par un élément conducteur ;
- la première et la dernière bande de l'âme thermoélectrique étant des éléments conducteurs ;
- chaque bande d'élément semi-conducteur de type $p_i$ ayant indépendamment des autres une longueur $L_{pi}$, une épaisseur $e_{pi}$ et une largeur $l_{pi}$ et que chaque bande d'élément semi-conducteur de type $n_j$ ayant indépendamment des autres une longueur $L_{nj}$, une épaisseur $e_{nj}$ et une largeur $l_{nj}$ ;
- lesdites bandes d'éléments semi-conducteurs de type p, n, $p_i$ et $n_j$ étant jointes aux éléments conducteurs uniquement le long de leur largeur lp, $l_n$, $l_{pi}$ ou $l_{nj}$ ;

avec

$$l_p > L_p \quad ; \quad l_n > L_n$$

$$L_p/e_p \geq 1 \quad ; \quad L_n/e_n \geq 1 \quad ;$$

$$l_{pi} > L_{pi} \quad ; \quad l_{nj} > L_{nj}$$

$$L_{pi}/e_{pi} \geq 1 \quad ; \quad L_{nj}/e_{nj} \geq 1$$

i allant de 0 à n et j allant de 0 à m, avec n+m$\geq$ 1 ; n et m étant des nombres entiers ; **caractérisée par le fait que** les bandes d'éléments semi-conducteurs de type p (2 ;12 ;22 ;32 ;42 ;52) et éventuellement $p_i$ et/ou n (3 ;13 ;23 ;33 ;43 ;53) et éventuellement $n_j$ sont réalisées en un matériau composite hybride thermoélectrique comprenant :

- une matrice polymère ;
- des charges thermoélectriques sous forme de particules dispersées au sein de la matrice polymère ;
- les charges thermoélectriques étant des alliages multicomposants semi-conducteurs de type p ou de type n comprenant au moins les éléments Bi et Te.

2. Ame thermoélectrique (10;20) selon la revendication 1, **caractérisée par le fait que** $l_p > 100 L_p$ ; $ln > 100 L_n$ ; $l_{pi} > 100 L_{pi}$ et $l_{nj} > 100 L_{nj}$.

3. Ame thermoélectrique (10;20) selon l'une des revendications 1 ou 2, **caractérisée par le fait que** $L_p/e_p \geq 100$ ; $L_n/e_n \geq 100$ ; $L_{pi}/e_{pi} \geq 100$ et $L_{nj}/e_{nj} \geq 100$.

4. Ame thermoélectrique (10;20) selon la revendication 1, **caractérisée par le fait que** la matrice polymère est un polymère thermoformable.

5. Ame thermoélectrique (10;20) selon la revendication 1, **caractérisée par le fait que** les alliages multicomposants semi-conducteurs de type p sont des alliages de $Bi_8Sb_{32}Te_{60}$ et les alliages multicomposants semi-conducteurs de type n sont des alliages de $Bi_{40}Te_{42}Se_{18}$ ou $Bi_{40}Te_{57}Se_3$.

6. Structure thermoélectrique comprenant au moins une âme thermoélectrique (10;20) telle que définie selon l'une des revendications 1 à 5 ; **caractérisée par le fait que** chaque élément conducteur (1;11;21;31;41;51) successif est en contact respectivement avec un potentiel thermique à une température T1 et un potentiel thermique à une température T2, avec T1>T2.

**7.** Structure thermoélectrique selon la revendication 6, **caractérisée par le fait qu'**elle comprend au moins une paroi supérieure (14;24;34;44;54) présentant un potentiel thermique à la température T1 ayant une surface inférieure (44b;54b) et une surface supérieure (44a;54a) et au moins une paroi inférieure (15;25;35;45;55) présentant un potentiel thermique à la température T2 ayant une surface inférieure (45a;55a) et une surface supérieure (45b;55b), **caractérisée par le fait que** l'âme thermoélectrique (10;20) est disposée entre lesdites parois supérieure (14;24;34;44;54) et inférieure (15;25;35;45;55), de telle façon que chaque élément conducteur (1;11;21;31;41;51) successif est en contact respectivement avec la surface inférieure (44b;54b) de la paroi supérieure (14;24;34;44;54) et avec la surface supérieure (45b;55b) de la paroi inférieure (15;25;35;45;55).

**8.** Structure thermoélectrique selon la revendication 7, **caractérisée par le fait que** l'âme thermoélectrique (10;20) est disposée entre les deux parois inférieure (15;25;35;45;55) et supérieure (14;24;34;44;54) de telle façon que :

- l'angle interne $\alpha_{(ps)}$ entre un élément conducteur (1;11;21;31;41;51) en contact avec la surface inférieure (44b;54b) de la paroi supérieure (14;24;34;44;54) et une bande adjacente d'élément semi-conducteur de type p (2;12;22;32;42;52) et l'angle alterne $\alpha_{(pi)}$ entre un élément conducteur (1;11;,21;31;41;51) successif en contact avec la surface supérieure (45b;55b) de la paroi inférieure (15;25;35;45;55) et la même bande adjacente d'élément semi-conducteur de type p (2;12;22;32;42;52) sont identiques et appelés angle $\alpha$ ; et éventuellement l'angle interne $\alpha i_{(ps)}$ entre un élément conducteur (1;11;21;31;41;51) en contact avec la surface inférieure (44b;54b) de la paroi supérieure (14;24;34;44;54) et une bande adjacente d'élément semi-conducteur de type $p_i$ (2;12;22;32;42;52) et l'angle alterne $\alpha i_{(pi)}$ entre un élément conducteur (1;11;21;31;41;51) successif en contact avec la surface supérieure (45b;55b) de la paroi inférieure (15;25;35;45;55) et la même bande adjacente d'élément semi-conducteur de type $p_i$ (2;12;22;32;42;52) sont identiques et appelés angle $\alpha i$ ; et
- que l'angle interne $\beta_{(ps)}$ entre un élément conducteur (1;11;21;31;41;51) en contact avec la surface inférieure (44b;54b) de la paroi supérieure (14;24;34;44;54) et une bande adjacente d'élément semi-conducteur de type n (3;13;23;33;43;53) et l'angle alterne $\beta_{(pi)}$ entre un élément conducteur (1;11;21;31;41;51) successif est en contact avec la surface supérieure (45b;55b) de la paroi inférieure (15;25;35;45;55) et la même bande adjacente d'élément semi-conducteur de type n (3;13;23;33;43;53) sont identiques et appelés angle $\beta$ ; et éventuellement l'angle interne $\beta_{j(ps)}$ entre un élément conducteur (1;11;21;31;41;51) en contact avec la surface inférieure (44b;54b) de la paroi supérieure (14;24;34;44;54) et une bande adjacente d'élément semi-conducteur de type $n_j$ (3;13;23;33;43;53) et l'angle alterne $\beta_{j(pi)}$ entre un élément conducteur (1;11;21;31;41;51) successif en contact avec la surface supérieure (45b ;55b) de la paroi inférieure (15 ;25 ;35 ;45 ;55) et la même bande adjacente d'élément semi-conducteur de type $n_j$ (3;13;23;33;43;53) sont identiques et appelés angle $\beta_j$;
avec 0°<$\alpha$<180° ; 0°<$\beta$<180° et éventuellement 0°<$\alpha_i$<180° ; 0°<$\beta_j$<180° :

i allant de 0 à n et j allant de 0 à m, avec n+m$\geq$ 1 ; n et m étant des nombres entiers.

**9.** Structure thermoélectrique selon la revendication 6 comprenant une paroi supérieure (14;24;34;44;54) présentant un potentiel thermique à une température T1 ayant une surface inférieure (44b;54b) et surface supérieure (44a;54a), une paroi inférieure (15;,25;,35;,45;,55) présentant également un potentiel thermique à une température T1 ayant une surface inférieure (45a;55a) et surface supérieure (45b;55b) et une paroi intermédiaire (56) présentant un potentiel thermique à une température T2 disposée entre les parois supérieure et inférieure, avec T1>T2, **caractérisée par le fait que** l'âme thermoélectrique (10;20) est disposée entre lesdites parois supérieure (14;24;34;44;,54) et inférieure (15;25;35;45;55), de telle façon que chaque élément conducteur (1;11;21;31;41;51) successif est en contact respectivement avec la surface inférieure (44b;54b) de la paroi supérieure (14;24;34;44;54), la paroi intermédiaire (56) et la surface supérieure (45b;55b) de la paroi inférieure (15;25;35;45; 55).

**10.** Structure thermoélectrique selon l'une des revendications 7 à 9, **caractérisée par le fait que** les parois supérieures (14 ; 24; 34; 44; 54) et inférieures (15; 25; 35; 45;55) sont deux parois planes et parallèles entre elles.

**11.** Structure thermoélectrique selon l'une des revendications 7 à 9, **caractérisée par le fait que** les parois supérieures (14; 24; 34; 44; 54) et inférieures (15; 25; 35; 45;55) sont deux cylindres concentriques.

**12.** Structure thermoélectrique selon la revendication 9, **caractérisée par le fait que** les parois intermédiaires (56) sont cylindriques.

**13.** Procédé de réalisation d'une structure thermoélectrique telle que définie selon l'une des revendications 7, 8, 10 et 11 comprenant les étapes suivantes :

(i) réaliser une jonction thermoélectrique ;

(ii) éventuellement joindre des bandes successives d'éléments semi-conducteurs de type $p_i$ et des bandes successives d'éléments semi-conducteurs de type $n_j$ séparées les unes des autres par un élément conducteur pour former l'âme thermoélectrique;

(iii) mettre en forme la dite âme thermoélectrique;

(iv) fixer la dite âme thermoélectrique entre une paroi supérieure ayant une surface inférieure et une surface supérieure et au moins une paroi inférieure ayant une surface inférieure et une surface supérieure de façon à ce que chaque élément conducteur successif soit collée respectivement à la surface inférieure de la paroi supérieure et à la surface supérieure de la paroi inférieure.

**14.** Procédé de réalisation d'une structure thermoélectrique telle que définie selon l'une des revendications 9 ou 12 comprenant les étapes suivantes :

(i) réaliser au moins une jonction thermoélectrique ;

(ii) éventuellement joindre des bandes successives d'éléments semi-conducteurs de type $p_i$ et les bandes successives d'éléments semi-conducteurs de type $n_j$ séparées les unes des autres par un élément conducteur pour former l'âme thermoélectrique;

(iii) mettre en forme la dite âme thermoélectrique;

(iv) fixer la dite âme thermoélectrique entre une paroi supérieure ayant une surface inférieure et une surface supérieure et au moins une paroi inférieure ayant une surface inférieure et une surface supérieure et au moins une paroi intermédiaire de façon à ce que chaque élément conducteur successif soit collée respectivement à la surface inférieure de la paroi supérieure, à la paroi intermédiaire et à la surface supérieure de la paroi inférieure.

**15.** Procédé selon l'une des revendications 13 ou 14, **caractérisée par le fait que** la réalisation de l'âme thermoélectrique est réalisée par pressage à chaud et comporte les étapes suivantes :

(i) placer dans une matrice de pressage présentant différents compartiments ayant une longueur, une largeur et une épaisseur donnée un élément conducteur dans un premier compartiment, un élément semi-conducteur de type p dans un second compartiment, un élément conducteur dans un troisième compartiment, un élément semi-conducteur de type n dans un quatrième compartiment et un élément conducteur dans un cinquième compartiment; et éventuellement une succession de bandes d'éléments semi-conducteurs de type $p_i$ et de type $n_j$ avec des éléments conducteurs intercalés entre lesdites bandes dans d'autres compartiments;

(ii) mettre en montée en température la matrice de pressage pour atteindre une température TEMP1;

(iii) augmenter la pression P dans la matrice de pressage ;

(iv) maintenir la température TEMP1 et la pression P pendant une durée t ;

(v) descendre en température à une température TEMP2 en maintenant la pression P ;

(vi) diminuer la pression jusqu'à la pression atmosphérique ;

(vii) démouler la matrice de pressage.

**16.** Procédé selon l'une des revendications 13 ou 14, **caractérisé par le fait que** la mise en forme de l'âme thermoélectrique est réalisée par thermoformage et comprend les étapes suivantes :

- placer un moule correspondant à la géométrie désirée, en fonction des angles $\alpha$, $\beta$, $\alpha_i$ et $\beta_j$ fixés, sur un plateau porte moule ;

- fixer l'âme thermoélectrique à un cadre situé bien au-dessus du moule;

- chauffer l'âme thermoélectrique afin de lui donner la plasticité nécessaire ;

- arrêter le chauffage une fois la plasticité requise ;

- relever le moule grâce au plateau porte-moule et le placer juste en dessous de l'âme thermoélectrique ;

- aspirer l'air résiduel entre le moule et l'âme thermoélectrique ;

- refroidir l'âme thermoélectrique et redescendre le moule à l'aide du plateau porte-moule.

**17.** Utilisation de la structure thermoélectrique telle que définie dans l'une des revendications 6 à 12 en tant que paroi chauffante basse température et/ou rafraichissante.

**18.** Utilisation de la structure thermoélectrique telle que définie dans l'une des revendications 6 à 12 en tant que radiateur actif chauffant basse température et/ou rafraichissant.

**Patentansprüche**

1. Thermoelektrischer Kern (10;20) mit einer thermoelektrische Kontaktstelle, der aufeinanderfolgend aus einem leitfähigen Element (1;11;21;31;41;51), einem Streifen Halbleiterelement des p-Typs (2;12;22;32;42;52) der Länge $L_p$, der Dicke $e_p$ und der Breite $l_p$, einem leitfähigen Element (1;11;21;31;41;51), einem Streifen Halbleiterelement des n-Typs (3;13;23;33;43;53) der Länge $L_n$, der Dicke $e_n$ und der Breite $l_n$ und einem leitfähigen Element (1;11;21;31;41;51); und gegebenenfalls aufeinanderfolgenden Streifen von Halbleiterelementen des $p_i$-Typs und Streifen von Halbleiterelementen des $n_j$-Typs besteht; wobei

- die Streifen von Halbleiterelementen, die den thermoelektrischen Kern bilden, auf eine solche Weise aufeinander folgen, dass Halbleiter des p-Typs und Halbleiter des n-Typs einander abwechseln;
- die Streifen von Halbleiterelementen des $p_i$-Typs und $n_j$-Typs durch ein leitfähiges Element getrennt sind;
- der erste Streifen und der letzte Streifen des thermoelektrischen Kerns leitfähige Elemente sind;
- jeder Streifen eines Halbleiterelements des $p_i$-Typs unabhängig von den anderen eine Länge $L_{pi}$, eine Dicke $e_{pi}$ und eine Breite $l_{pi}$ hat und jeder Streifen eines Halbleiterelements des $n_j$-Typs unabhängig von den anderen eine Länge $L_{nj}$, eine Dicke $e_{nj}$ und eine Breite $l_{nj}$ hat;
- die Streifen von Halbleiterelementen des p-, n-, $p_i$ und $n_j$-Typs nur entlang ihrer Breiten $l_p$, $l_n$, $l_{pi}$ oder $l_{nj}$ mit den leitfähigen Elementen verbunden sind;

wobei:

$$l_p > L_p \; ; \; l_n > L_n$$

$$L_p/e_p \geq 1 \; ; \; L_n/e_n \geq 1;$$

$$l_{pi} > L_{pi} \; ; \; l_{nj} > L_{nj}$$

$$L_{pi}/e_{pi} \geq 1 \; ; \; L_{nj}/e_{nj} \geq 1$$

wobei i von 0 bis n läuft und j von 0 bis m läuft, mit $n+m \geq 1$; und n und m ganze Zahlen sind; **dadurch gekennzeichnet, dass** die Streifen von Halbleiterelementen des p-Typs (2;12;22;32;42;52) und gegebenenfalls $p_i$-Typs und/oder n-Typs (3;13;23;33;43;53) und gegebenenfalls $n_j$-Typs aus einem hybriden thermoelektrischen Verbundmaterial hergestellt sind, das aufweist:

- eine Polymermatrix;
- thermoelektrische Ladungen in Form von Partikeln, die in der Polymermatrix verteilt sind;
- die thermoelektrischen Ladungen mehrkomponentige Legierungen von Halbleitern des p-Typs oder n-Typs sind, die mindestens die Elemente Bi und Te aufweisen.

2. Thermoelektrischer Kern (10;20) nach Anspruch 1, **dadurch gekennzeichnet, dass** $l_p > 100L_p$; $l_n > 100L_n$; $l_{pi} > 100L_{pi}$ und $l_{nj} > 100L_{nj}$ ist.

3. Thermoelektrischer Kern (10;20) nach einem der Ansprüche 1 oder 2, **dadurch gekennzeichnet, dass** $L_p/e_p \geq 100$; $L_n/e_n \geq 100$; $L_{pi}/e_{pi} \geq 100$ und $L_{nj}/e_{nj} \geq 100$ ist.

4. Thermoelektrischer Kern (10;20) nach Anspruch 1, **dadurch gekennzeichnet, dass** die Polymermatrix ein warmverformbares Polymer ist.

5. Thermoelektrischer Kern (10;20) nach Anspruch 1, **dadurch gekennzeichnet, dass** die mehrkomponentigen Legierungen von Halbleitern des p-Typs $Bi_8Sb_{32}Te_{60}$-Legierungen sind und die mehrkomponentigen Legierungen von Halbleitern des n-Typs $Bi_{40}Te_{42}Se_{18}$- oder $Bi_{40}Te_{57}Se_3$-Legierungen sind.

6. Thermoelektrische Struktur, die mindestens einen thermoelektrischen Kern (10;20) aufweist, wie er in einem der Ansprüche 1 bis 5 definiert ist; **dadurch gekennzeichnet, dass** jedes aufeinanderfolgende leitfähige Element (1;11;21;31;41;51) jeweils in Kontakt ist mit einem thermischen Potential bei einer Temperatur T1 und einem thermischen Potential bei einer Temperatur T2, wobei T1>T2.

**7.** Thermoelektrische Struktur nach Anspruch 6, **dadurch gekennzeichnet, dass** sie aufweist:

mindestens eine obere Wand (14;24;34;44;54), die ein thermisches Potential bei einer Temperatur T1 hat und eine untere Fläche (44b;54b) und eine obere Fläche (44a;54a) aufweist, und mindestens eine untere Wand (15;25;35;45;55), die ein thermisches Potential bei einer Temperatur T2 hat und eine untere Fläche (45a;55a) und eine obere Fläche (45b;55b) aufweist,
**dadurch gekennzeichnet, dass**
der thermoelektrische Kern (10;20) zwischen der oberen (14;24;34;44;54) und unteren (15;25;35;45;55) Wand angeordnet ist, derart, dass jedes aufeinanderfolgende leitfähige Element (1;11;21;31;41;51) jeweils in Kontakt ist mit der unteren Fläche (44b;54b) der oberen Wand (14;24;34;44;54) und mit der oberen Fläche (45b;55b) der unteren Wand (15;25;35;45;55).

**8.** Thermoelektrische Struktur nach Anspruch 7, **dadurch gekennzeichnet, dass** der thermoelektrische Kern (10;20) zwischen den zwei Wänden, d.h. der unteren (15;25;35;45;55) und der oberen (14;24;34;44;54), angeordnet ist, derart, dass

- der Innenwinkel $\alpha_{(ps)}$ zwischen einem leitfähigen Element (1;11;21;31;41;51) in Kontakt mit der unteren Fläche (44b;54b) der oberen Wand (14;24;34;44;54) und einem angrenzenden Streifen Halbleiterelement des p-Typs (2;12;22;32;42;52) und der Wechselwinkel $\alpha_{(pi)}$ zwischen einem darauffolgenden leitfähigen Element (1;11;21;31;41;51) in Kontakt mit der oberen Fläche (45b;55b) der unteren Wand (15;25;35;45;55) und demselben angrenzenden Streifen Halbleiterelement des p-Typs (2;12;22;32;42;52) gleich groß sind und mit Winkel $\alpha$ bezeichnet sind; und gegebenenfalls der Innenwinkel $\alpha_{i(ps)}$ zwischen einem leitfähigen Element (1;11;21;31;41;51) in Kontakt mit der unteren Fläche (44b;54b) der oberen Wand (14;24;34;44;54) und einem angrenzenden Streifen Halbleiterelement des $p_i$-Typs (2;12;22;32;42;52) und der Wechselwinkel $\alpha_{i(pi)}$ zwischen einem darauffolgenden leitfähigen Element (1;11;21;31;41;51) in Kontakt mit der oberen Fläche (45b;55b) der unteren Wand (15;25;35;45;55) und demselben angrenzenden Streifen Halbleiterelement des $p_i$-Typs (2;12;22;32;42;52) gleich groß sind und mit Winkel $\alpha_i$ bezeichnet sind; und
- dass der Innenwinkel $\beta_{(ps)}$ zwischen einem leitfähigen Element (1;11;21;31;41;51) in Kontakt mit der unteren Fläche (44b;54b) der oberen Wand (14;24;34;44;54) und einem angrenzenden Streifen Halbleiterelement des n-Typs (3;13;23;33;43;53) und der Wechselwinkel $\beta_{(pi)}$ zwischen einem darauffolgenden leitfähigen Element (1;11;21;31;41;51) in Kontakt mit der oberen Fläche (45b;55b) der unteren Wand (15;25;35;45;55) und demselben angrenzenden Streifen Halbleiterelement des n-Typs (3;13;23;33;43;53) gleich groß sind und mit Winkel $\beta$ bezeichnet sind; und gegebenenfalls der Innenwinkel $\beta_{j(ps)}$ zwischen einem leitfähigen Element (1;11;21;31;41;51) in Kontakt mit der unteren Fläche (44b;54b) der oberen Wand (14;24;34;44;54) und einem angrenzenden Streifen Halbleiterelement des $n_j$-Typs (3;13;23;33;43;53) und der Wechselwinkel $\beta_{j(pi)}$ zwischen einem darauffolgenden leitfähigen Element (1;11;21;31;41;51) in Kontakt mit der oberen Fläche (45b;55b) der unteren Wand (15;25;35;45;55) und demselben angrenzenden Streifen Halbleiterelement des $n_j$-Typs (3;13;23;33;43;53) gleich groß sind und mit Winkel $\beta_j$ bezeichnet sind;
wobei:

$0°<\alpha<180°$; $0°<\beta<180°$ und gegebenenfalls $0°<\alpha_i<180°$; $0°<\beta_j<180°$;
wobei i von 0 bis n läuft und j von 0 bis m läuft, mit $n+m\geq1$, und
n und m ganze Zahlen sind.

**9.** Thermoelektrische Struktur nach Anspruch 6, die aufweist:

eine obere Wand (14;24;34;44;54), die ein thermisches Potential bei einer Temperatur T1 hat und eine untere Fläche (44b;54b) und eine obere Fläche (44a;54a) aufweist, eine untere Wand (15;25;35;45;55), die ebenfalls ein thermisches Potential bei einer Temperatur T1 hat und eine untere Fläche (45a;55a) und eine obere Fläche (45b;55b) aufweist, und eine zwischen der oberen Wand und der unteren Wand angeordnete Zwischenwand (56), die ein thermisches Potential bei einer Temperatur T2 hat, wobei T1>T2,
**dadurch gekennzeichnet, dass**
der thermoelektrische Kern (10;20) zwischen der oberen (14;24;34;44;54) und unteren (15;25;35;45;55) Wand angeordnet ist, derart, dass jedes aufeinanderfolgende leitfähige Element (1;11;21;31;41;51) in Kontakt ist mit der unteren Fläche (44b;54b) der oberen Wand (14;24;34;44;54), der Zwischenwand (56) und der oberen Fläche (45b;55b) der unteren Wand (15;25;35;45;55).

10. Thermoelektrische Struktur nach einem der Ansprüche 7 bis 9, **dadurch gekennzeichnet, dass** die obere (14;24;34;44;54) und untere (15;25;35;45;55) Wand zwei ebene und zueinander parallele Wände sind.

11. Thermoelektrische Struktur nach einem der Ansprüche 7 bis 9, **dadurch gekennzeichnet, dass** die obere (14;24;34;44;54) und untere (15;25;35;45;55) Wand zwei konzentrische Zylinder sind.

12. Thermoelektrische Struktur nach Anspruch 9, **dadurch gekennzeichnet, dass** die Zwischenwände (56) zylindrisch sind.

13. Verfahren zur Herstellung einer thermoelektrischen Struktur, wie sie in einem der Ansprüche 7, 8, 10 und 11 definiert ist, wobei das Verfahren die folgenden Schritte aufweist:

(i) Herstellen einer thermoelektrischen Kontaktstelle;
(ii) gegebenenfalls Verbinden von aufeinanderfolgenden Streifen von Halbleiterelementen des $p_i$-Typs und Streifen von Halbleiterelementen des $n_j$-Typs, die voneinander durch ein leitfähiges Element getrennt sind, um einen thermoelektrischen Kern zu bilden;
(iii) Anwenden eines Formgebungsprozesses auf den thermoelektrischen Kern;
(iv) Befestigen des thermoelektrischen Kerns zwischen einer oberen Wand, die eine untere Fläche und eine obere Fläche hat, und mindestens einer unteren Wand, die eine untere Fläche und eine obere Fläche hat, derart, dass jedes aufeinanderfolgende leitfähige Element der Folge jeweils an der unteren Fläche der oberen Wand und an der oberen Fläche der unteren Wand angeklebt wird.

14. Verfahren zur Herstellung einer thermoelektrischen Struktur, wie sie in einem der Ansprüche 9 oder 12 definiert ist, wobei das Verfahren die folgenden Schritte aufweist:

(i) Herstellen mindestens einer thermoelektrischen Kontaktstelle;
(ii) gegebenenfalls Verbinden von aufeinanderfolgenden Streifen von Halbleiterelementen des $p_i$-Typs und Streifen von Halbleiterelementen des $n_j$-Typs, die voneinander durch ein leitfähiges Element getrennt sind, um einen thermoelektrischen Kern zu bilden;
(iii) Anwenden eines Formgebungsprozesses auf den thermoelektrischen Kern;
(iv) Befestigen des thermoelektrischen Kerns zwischen einer oberen Wand, die eine untere Fläche und eine obere Fläche hat, und mindestens einer unteren Wand, die eine untere Fläche und eine obere Fläche hat, und mindestens einer Zwischenwand, derart, dass jedes aufeinanderfolgende leitfähige Element jeweils an der unteren Fläche der oberen Wand, an der Zwischenwand und an der oberen Fläche der unteren Wand angeklebt wird.

15. Verfahren nach einem der Ansprüche 13 oder 14, **dadurch gekennzeichnet, dass** die Herstellung des thermoelektrischen Kerns durch Heißpressen erfolgt und die folgenden Schritte aufweist:

(i) Bereitstellen einer Pressmatrix mit verschiedenen Räumen einer gegebenen Länge, Breite und Dicke und Anordnen eines leitfähigen Elements in einem ersten Raum, eines Halbleiterelements des p-Typs in einem zweiten Raum, eines leitfähigen Elements in einem dritten Raum, eines Halbleiterelements des n-Typs in einem vierten Raum und eines leitfähigen Elements in einem fünften Raum; und gegebenenfalls Anordnen von aufeinanderfolgenden Streifen von Halbleiterelementen des $p_i$-Typs und des $n_j$-Typs, mit dazwischen liegenden Streifen von leitfähigen Elementen, in anderen Räumen;
(ii) Anwenden einer Temperaturerhöhung auf die Pressmatrix, um eine Temperatur TEMP1 zu erreichen;
(iii) Erhöhen des Drucks P in der Pressmatrix;
(iv) Halten der Temperatur TEMP1 und des Drucks P während einer Zeitdauer t;
(v) Senken der Temperatur auf eine Temperatur TEMP2 unter Aufrechterhaltung des Drucks P;
(vi) Verringern des Drucks bis auf Atmosphärendruck;
(vii) Herausnehmen aus der Pressmatrix.

16. Verfahren nach einem der Ansprüche 13 oder 14, **dadurch gekennzeichnet, dass** die Formgebung des thermoelektrischen Kerns durch einen Warmverformungsprozess erfolgt, der die folgenden Schritte aufweist:

- Anordnen eines Formwerkzeugs, das der gewünschten Geometrie entspricht, in Abhängigkeit von den vorgegebenen Winkeln $\alpha$, $\beta$, $\alpha_i$ und $\beta_j$ auf einer Formwerkzeug-Trägerplatte;
- Befestigen des thermoelektrischen Kerns an einem Rahmen, der oberhalb des Formwerkzeugs angeordnet ist;
- Erhitzen des thermoelektrischen Kerns, um ihm die erforderliche Plastizität zu geben;
- Beenden des Erhitzens sobald die erforderliche Plastizität erreicht ist;
- Anheben des Formwerkzeugs mit Hilfe der Formwerkzeug-Trägerplatte, um es genau unterhalb des thermoelektrischen Kerns anzuordnen;
- Absaugen von Restluft zwischen dem Formwerkzeug und dem thermoelektrischen Kern;
- Kühlen des thermoelektrischen Kerns und Absenken des Formwerkzeugs mit Hilfe der Formwerkzeug-Trägerplatte.

17. Verwendung der thermoelektrischen Struktur, wie sie in einem der Ansprüche 6 bis 12 definiert ist, als heizende und/oder kühlende Niedertemperaturwand.

18. Verwendung der thermoelektrischen Struktur, wie sie in einem der Ansprüche 6 bis 12 definiert ist, als heizender und/oder kühlender aktiver Niedertemperatur-Radiator.

**Claims**

1. Thermoelectric core (10; 20) comprising a thermoelectric junction consisting of a series of conductive elements (1; 11; 21; 31; 41; 51), of a strip of semiconductor elements of the p type (2; 12; 22; 32; 42; 52) of length $L_p$, of thickness $e_p$ and of width lp, of a conductive element (1; 11; 21; 31; 41; 51), of a strip of semiconductor elements of the n type (3; 13; 23; 33; 43; 53) of length $L_n$, of thickness $e_n$ and of width $l_n$ and of a conductive element (1; 11;21;31;41;51); and possibly of a series of strips of semiconductor elements of the $p_i$ type and of strips of semiconductor elements of the $n_j$ type;

   - the strips of semiconductor elements comprised in the thermoelectric core follow one another in such a way that an alternation between type-p semiconductors and type-n semiconductors is provided;
   - the strips of semiconductor elements of the $p_i$ and $n_j$ type being separated by a conductive element;
   - the first and the last strip of the thermoelectric core being conductive elements;
   - each strip of semiconductor element of the $p_i$ type having independently from the others a length $L_{pi}$, a thickness $e_{pi}$ and a width $l_{pi}$ and each strip of semiconductor element of the $n_j$ type having independently from the others a length $L_{nj}$, a thickness $e_{nj}$ and a width $l_{nj}$;
   - said strips of semiconductor elements of the p, n, $p_i$ and $n_j$ type being attached to the conductive elements solely along their width lp, $l_n$, $l_{pi}$ or $l_{nj}$;

   with

   $$l_p > L_p;\ l_n > L_n$$

   $$L_p/e_p \geq l;\ L_n/e_n \geq l;$$

   $$l_{pi} > L_{pi};\ l_{nj} > L_{nj}$$

   $$L_{pi}/e_{pi} \geq l;\ L_{nj}/e_{nj} \geq l$$

   i ranging from 0 to n and j ranging from 0 to m, with $n+m \geq 1$; n and m being integers; **characterised by** the fact that the strips of semiconductor elements of the p type (2; 12; 22; 32; 42; 52) and possibly $p_i$ and/or n (3; 13; 23; 33; 43; 53) and possibly $n_j$ type are made from a thermoelectric hybrid composite material comprising:

   - a polymer matrix;
   - thermoelectric loads in the form of particles dispersed in the polymer matrix;

- the thermoelectric loads being multi-component alloy semiconductors of the p type or of the n type comprising at least the elements Bi and Te.

2. Thermoelectric core (10; 20) according to claim 1, **characterised by** the fact that $I_p>100L_p$; $In>100L_n$; $I_{pi}>100L_{pi}$ and $I_{nj}>100L_{nj}$.

3. Thermoelectric core (10; 20) according to one of claims 1 or 2, **characterised by** the fact that $L_p/e_p\geq100$; $L_n/e_n\geq100$; $L_{pi}/e_{pi}\geq100$ and $L_{nj}/e_{nj}\geq100$.

4. Thermoelectric core (10; 20) according to claim 1, **characterised by** the fact that the polymer matrix is a thermoformable polymer.

5. Thermoelectric core (10; 20) according to claim 1, **characterised by** the fact that the multi-component alloy semiconductors of the p type are alloys of $Bi_8Sb_{32}Te_{60}$ and the multi-component alloy semiconductors of the n type are alloys of $Bi_{40}Te_{42}Se_{18}$ or $Bi_{40}Te_{57}Se_3$.

6. Thermoelectric structure comprising at least one thermoelectric core (10; 20) such as defined according to one of claims 1 to 5; **characterised by** the fact that each successive conductive element (1; 11; 21; 31; 41; 51) is in contact respectively with a thermal potential at a temperature T1 and a thermal potential at a temperature T2, with T1>T2.

7. Thermoelectric structure according to claim 6, **characterised by** the fact that it comprises at least one upper wall (14; 24; 34; 44; 54) having a thermal potential at the temperature T1 having a lower surface (44b; 54b) and an upper surface (44a; 54a) and at least one lower wall (15; 25; 35; 45; 55) having a thermal potential at the temperature T2 having a lower surface (45a; 55a) and an upper surface (45b; 55b), **characterised by** the fact that the thermoelectric core (10; 20) is arranged between said upper (14; 24; 34; 44; 54) and lower (15; 25; 35; 45; 55) walls, in such a way that each successive conductive element (1; 11; 21; 31; 41; 51) is in contact respectively with the lower surface (44b; 54b) of the upper wall (14; 24; 34; 44; 54) and with the upper surface (45b; 55b) of the lower wall (15; 25; 35; 45; 55).

8. Thermoelectric structure according to claim 7, **characterised by** the fact that the thermoelectric core (10; 20) is arranged between the two lower (15; 25; 35; 45; 55) and upper (14; 24; 34; 44; 54) walls in such a way that:

- the internal angle $\alpha_{(ps)}$ between a conductive element (1; 11; 21; 31; 41; 51) in contact with the lower surface (44b; 54b) of the upper wall (14; 24; 34; 44; 54) and an adjacent strip of semiconductor element of the p type (2; 12; 22; 32; 42; 52) and the alternate angle $\alpha_{(pi)}$ between a successive conductive element (1; 11; 21; 31; 41; 51) in contact with the upper surface (45b; 55b) of the lower wall (15; 25; 35; 45; 55) and the same adjacent strip of semiconductor element of the p type (2; 12; 22; 32; 42; 52) are identical and referred to as angle $\alpha$; and possibly the internal angle $\alpha i_{(ps)}$ between a conductive element (1; 11; 21; 31; 41; 51) in contact with the lower surface (44b; 54b) of the upper wall (14; 24; 34; 44; 54) and an adjacent strip of semiconductor element of the $p_i$ type (2; 12; 22; 32; 42; 52) and the alternate angle $\alpha i_{(pi)}$ between a successive conductive element (1; 11; 21; 31; 41; 51) in contact with the upper surface (45b; 55b) of the lower wall (15; 25; 35; 45; 55) and the same adjacent strip of semiconductor element of the $p_i$ type (2; 12; 22; 32; 42; 52) are identical and referred to as angle $\alpha i$; and
- that the internal angle $\beta_{(ps)}$ between a conductive element (1; 11; 21; 31; 41; 51) in contact with the lower surface (44b; 54b) of the upper wall (14; 24; 34; 44; 54) and an adjacent strip of semiconductor element of the n type (3; 13; 23; 33; 43; 53) and the alternate angle $\beta_{(pi)}$ between a successive conductive element (1; 11; 21; 31; 41; 51) is in contact with the upper surface (45b; 55b) of the lower wall (15; 25; 35; 45; 55) and the same adjacent strip of semiconductor element of the n type (3; 13; 23; 33; 43; 53) are identical and referred to as angle $\beta$; and possibly the internal angle $\beta_{j(ps)}$ between a conductive element (1; 11; 21; 31; 41; 51) in contact with the lower surface (44b; 54b) of the upper wall (14; 24; 34; 44; 54) and an adjacent strip of semiconductor element of the $n_j$ type (3; 13; 23; 33; 43; 53) and the alternate angle $\beta_{j(pi)}$ between a successive conductive element (1; 11; 21; 31; 41; 51) in contact with the upper surface (45b; 55b) of the lower wall (15; 25; 35; 45; 55) and the same adjacent strip of semiconductor element of the $n_j$ type (3; 13; 23; 33; 43; 53) are identical and referred to as angle $\beta_j$;

with $0°<\alpha<180°$; $0°<\beta<180°$ and possibly $0°<\alpha_i<180°$; $0°<\beta_j<180°$;
with i ranging from 0 to n and j ranging from 0 to m, with $n+m\geq 1$; n and m being integers.

9. Thermoelectric structure according to claim 6 comprising an upper wall (14; 24; 34; 44; 54) having a thermal potential at a temperature T1 having a lower surface (44b; 54b) and upper surface (44a; 54a), a lower wall (15; 25; 35; 45; 55) also having a thermal potential at a temperature T1 having a lower surface (45a; 55a) and upper surface (45b; 55b) and an intermediate wall (56) having a thermal potential at a temperature T2 arranged between the upper and lower walls, with T1>T2, **characterised by** the fact that the thermoelectric core (10; 20) is arranged between said upper (14; 24; 34; 44; 54) and lower (15; 25; 35; 45; 55) walls, in such a way that each successive conductive element (1; 11; 21; 31; 41; 51) is in contact respectively with the lower surface (44b; 54b) of the upper wall (14; 24; 34; 44; 54), the intermediate wall (56) and the upper surface (45b; 55b) of the lower wall (15; 25; 35; 45; 55).

10. Thermoelectric structure according to one of claims 7 to 9, **characterised by** the fact that the upper (14; 24; 34; 44; 54) and lower (15; 25; 35; 45; 55) walls are two planar walls parallel to each other.

11. Thermoelectric structure according to one of claims 7 to 9, **characterised by** the fact that the upper (14; 24; 34; 44; 54) and lower (15; 25; 35; 45; 55) walls are two concentric cylinders.

12. Thermoelectric structure according to claim 9, **characterised by** the fact that the intermediate walls (56) are cylindrical.

13. Method for carrying out a thermoelectric structure such as defined according to one of claims 7, 8, 10 and 11 comprising the following steps:

(i) carrying out a thermoelectric junction;
(ii) possibly attaching successive strips of semiconductor elements of the $p_i$ type and successive strips of semiconductor elements of the $n_j$ type separated from each other by a conductive element in order to form the thermoelectric core;
(iii) shaping said thermoelectric core;
(iv) fixing said thermoelectric core between an upper wall having a lower surface and an upper surface and at least one lower wall having a lower surface and an upper surface in such a way that each successive conductive element is glued respectively to the lower surface of the upper wall and to the upper surface of the lower wall.

14. Method for carrying out a thermoelectric structure such as defined according to one of claims 9 or 12 comprising the following steps:

(i) carrying out at least one thermoelectric junction;
(ii) possibly attaching successive strips of semiconductor elements of the $p_i$ type and the successive strips of semiconductor elements of the $n_j$ type separated from each other by a conductive element in order to form the thermoelectric core;
(iii) shaping said thermoelectric core;
(iv) fixing said thermoelectric core between an upper wall having a lower surface and an upper surface and at least one lower wall having a lower surface and an upper surface and at least one intermediate wall in such a way that each successive conductive element is glued respectively to the lower surface of the upper wall, to the intermediate wall and to the upper surface of the lower wall.

15. Method according to one of claims 13 or 14, **characterised by** the fact that the carrying out of the thermoelectric core is accomplished through hot pressing and comprises the following steps:

(i) placing in a press matrix having different compartments having a length, a width and a given thickness a conductive element in a first compartment, a semiconductor element of the p type in a second compartment, a conductive element in a third compartment, a semiconductor element of the n type in a fourth compartment and a conductive element in a fifth compartment; and possibly a series of strips of semiconductor elements of the $p_i$ type and of the $n_j$ type with conductive elements inserted between said strips in other compartments;
(ii) increasing the temperature of the press matrix in order to reach a temperature TEMP1;
(iii) increasing the pressure P in the press matrix;
(iv) maintaining the temperature TEMP1 and the pressure P for a duration t;
(v) lowering in temperature to a temperature TEMP2 while maintaining the pressure P;
(vi) decreasing the pressure to atmospheric pressure;
(vii) unmoulding the press matrix.

16. Method according to one of claims 13 or 14, **characterised by** the fact that the shaping of the thermoelectric core is carried out by thermoforming and comprises the following steps:

   - placing a mould corresponding to the desired geometry, according to angles $\alpha$, $\beta$, $\alpha_i$ and $\beta_j$ fixed, on a mould holding plate;
   - fixing the thermoelectric core to a frame located well above the mould;
   - heating the thermoelectric core in order to give it the required plasticity;
   - stopping the heating once the required plasticity is obtained;
   - raising the mould using the mould holding plate and placing it just below the thermoelectric core;
   - sucking the residual air between the mould and the thermoelectric core;
   - cooling the thermoelectric core and lowering the mould using the mould holding plate.

17. Use of the thermoelectric structure such as defined in one of claims 6 to 12 as a low temperature and/or cooling wall.

18. Use of the thermoelectric structure such as defined in one of claims 6 to 12 as a low temperature and/or cooling active radiator.

Figure 1

Figure 2

Figure 2a

Figure 3

Figure 4

Figure 5

Figure 6

| | |
|---|---|
| P >1250 | |
| 900< P <1250 | |
| 600< P <900 | |
| 300< P <600 | |
| 150< P <300 | |
| 50< P <150 | |
| P <50 | |

Pco Pmax (W)

| e(mm) \ L(mm) | 100 | 70 | 50 | 40 | 30 | 20 | 10 | 8 | 6 | 4 | 3 | 2 | 1 |
|---|---|---|---|---|---|---|---|---|---|---|---|---|---|
| 0 | 0.06 | 0.09 | 0.12 | 0.15 | 0.20 | 0.30 | 0.60 | 0.75 | 1.00 | 1.49 | 1.99 | 2.99 | 5.97 |
| 5 | 0.30 | 0.43 | 0.60 | 0.75 | 1.00 | 1.49 | 2.99 | 3.73 | 4.98 | 7.50 | 9.95 | 14.93 | 29.86 |
| 10 | 0.60 | 0.85 | 1.19 | 1.49 | 1.99 | 2.99 | 5.97 | 7.46 | 9.95 | 14.93 | 19.90 | 29.86 | 59.71 |
| 50 | 2.99 | 4.27 | 5.97 | 7.46 | 9.95 | 14.93 | 29.86 | 37.32 | 49.76 | 74.64 | 99.52 | 149.28 | 298.55 |
| 100 | 5.97 | 8.53 | 11.94 | 14.93 | 19.90 | 29.86 | 59.71 | 74.64 | 99.52 | 149.28 | 199.04 | 298.55 | 597.11 |
| 150 | 8.96 | 12.80 | 17.91 | 22.39 | 29.86 | 44.78 | 89.57 | 111.96 | 149.28 | 223.91 | 298.55 | 447.83 | 895.66 |
| 200 | 11.94 | 17.06 | 23.88 | 29.86 | 39.81 | 59.71 | 119.42 | 149.28 | 199.04 | 298.55 | 398.07 | 597.11 | 1194.21 |
| 250 | 14.93 | 21.33 | 29.89 | 37.32 | 49.76 | 74.64 | 149.28 | 186.60 | 248.79 | 373.19 | 497.59 | 746.38 | 1492.77 |
| 300 | 17.91 | 25.59 | 35.83 | 44.78 | 59.71 | 89.57 | 179.13 | 223.91 | 298.55 | 447.83 | 597.11 | 895.66 | 1791.32 |
| 350 | 20.90 | 29.86 | 41.80 | 52.25 | 69.66 | 104.49 | 208.99 | 261.23 | 348.31 | 522.47 | 696.62 | 1044.94 | 2089.87 |
| 400 | 23.88 | 34.12 | 47.77 | 59.71 | 79.61 | 119.42 | 238.84 | 298.55 | 398.07 | 597.11 | 796.14 | 1194.21 | 2388.43 |
| 450 | 26.86 | 38.39 | 53.74 | 67.17 | 89.57 | 134.35 | 268.70 | 335.87 | 447.83 | 671.74 | 895.66 | 1343.49 | 2686.98 |
| 500 | 29.86 | 42.65 | 59.71 | 74.64 | 99.52 | 149.28 | 298.55 | 373.19 | 497.59 | 746.38 | 995.18 | 1492.77 | 2985.53 |
| 550 | 32.84 | 46.92 | 65.68 | 82.10 | 109.47 | 164.20 | 328.41 | 410.51 | 547.35 | 821.02 | 1094.69 | 1642.04 | 3284.08 |
| 600 | 35.83 | 51.18 | 71.65 | 89.57 | 119.42 | 179.13 | 358.26 | 447.83 | 597.11 | 895.66 | 1194.21 | 1791.32 | 3582.64 |
| 650 | 38.81 | 55.45 | 77.62 | 97.03 | 129.37 | 194.06 | 388.12 | 485.15 | 646.87 | 970.30 | 1293.73 | 1940.60 | 3881.19 |
| 700 | 41.80 | 59.71 | 83.60 | 104.49 | 139.32 | 208.99 | 417.97 | 522.47 | 696.62 | 1044.94 | 1393.25 | 2089.87 | 4179.74 |
| 750 | 44.78 | 63.98 | 89.57 | 111.96 | 149.28 | 223.91 | 447.83 | 559.79 | 746.38 | 1119.57 | 1492.77 | 2239.15 | 4478.30 |
| 800 | 47.77 | 68.24 | 95.54 | 119.42 | 159.23 | 238.84 | 477.69 | 597.11 | 796.14 | 1194.21 | 1592.28 | 2388.43 | 4776.85 |
| 850 | 50.75 | 72.51 | 101.51 | 126.89 | 169.18 | 253.77 | 507.54 | 634.43 | 845.90 | 1268.85 | 1691.80 | 2537.70 | 5075.40 |
| 900 | 53.74 | 76.77 | 107.48 | 134.35 | 179.13 | 268.70 | 537.40 | 671.74 | 895.66 | 1343.49 | 1791.32 | 2686.98 | 5373.96 |
| 950 | 56.73 | 81.04 | 113.45 | 141.81 | 189.08 | 283.63 | 567.25 | 709.06 | 945.42 | 1418.13 | 1890.84 | 2836.26 | 5672.51 |
| 1000 | 59.71 | 85.30 | 119.42 | 149.28 | 199.04 | 298.55 | 597.11 | 746.38 | 995.18 | 1492.76 | 1990.35 | 2985.53 | 5971.06 |

Tableau 2

| I >350 | 100< I <350 | 50< I <100 | 20< I <50 | I <20 |
|---|---|---|---|---|

$I_{COPmax}$ (A)

| L (mm) / e (mm) | 1 | 2 | 3 | 4 | 6 | 8 | 10 | 20 | 30 | 40 | 50 | 70 | 100 |
|---|---|---|---|---|---|---|---|---|---|---|---|---|---|
| 1 | 0.68 | 0.34 | 0.23 | 0.17 | 0.11 | 0.08 | 0.07 | 0.03 | 0.02 | 0.02 | 0.01 | 0.01 | 0.01 |
| 5 | 3.4 | 1.70 | 1.13 | 0.85 | 0.57 | 0.42 | 0.34 | 0.17 | 0.11 | 0.08 | 0.07 | 0.05 | 0.03 |
| 10 | 6.79 | 3.40 | 2.26 | 1.70 | 1.13 | 0.85 | 0.68 | 0.34 | 0.23 | 0.17 | 0.14 | 0.10 | 0.07 |
| 50 | 33.96 | 16.98 | 11.32 | 8.49 | 5.66 | 4.24 | 3.40 | 1.70 | 1.13 | 0.85 | 0.68 | 0.49 | 0.34 |
| 100 | 67.92 | 33.96 | 22.64 | 16.98 | 11.32 | 8.49 | 6.79 | 3.40 | 2.26 | 1.70 | 1.36 | 0.97 | 0.68 |
| 150 | 101.88 | 50.94 | 33.96 | 25.47 | 16.98 | 12.73 | 10.19 | 5.09 | 3.40 | 2.55 | 2.04 | 1.46 | 1.02 |
| 200 | 135.83 | 67.92 | 45.28 | 33.96 | 22.64 | 16.98 | 13.58 | 6.79 | 4.53 | 3.40 | 2.72 | 1.94 | 1.36 |
| 250 | 169.79 | 84.90 | 56.60 | 42.45 | 28.30 | 21.22 | 16.98 | 8.49 | 5.66 | 4.24 | 3.40 | 2.43 | 1.70 |
| 300 | 203.75 | 101.88 | 67.92 | 50.94 | 33.96 | 25.47 | 20.38 | 10.19 | 6.79 | 5.09 | 4.08 | 2.91 | 2.04 |
| 350 | 237.71 | 118.85 | 79.24 | 59.43 | 39.62 | 29.71 | 23.77 | 11.89 | 7.92 | 5.94 | 4.75 | 3.40 | 2.38 |
| 400 | 271.67 | 135.83 | 90.56 | 67.92 | 45.28 | 33.96 | 27.17 | 13.58 | 9.06 | 6.79 | 5.43 | 3.88 | 2.72 |
| 450 | 305.63 | 152.81 | 101.88 | 76.41 | 50.94 | 38.20 | 30.56 | 15.28 | 10.19 | 7.69 | 6.11 | 4.37 | 3.07 |
| 500 | 339.58 | 169.79 | 113.20 | 84.90 | 56.60 | 42.45 | 33.96 | 16.98 | 11.32 | 8.49 | 6.79 | 4.85 | 3.40 |
| 550 | 373.54 | 186.77 | 124.51 | 93.39 | 62.26 | 46.69 | 37.35 | 18.68 | 12.45 | 9.34 | 7.47 | 5.34 | 3.74 |
| 600 | 407.50 | 203.75 | 135.83 | 101.88 | 67.92 | 50.94 | 40.75 | 20.38 | 13.58 | 10.19 | 8.15 | 5.82 | 4.08 |
| 650 | 441.45 | 220.73 | 147.15 | 110.37 | 73.58 | 55.18 | 44.15 | 22.07 | 14.72 | 11.04 | 8.83 | 6.31 | 4.41 |
| 700 | 475.42 | 237.71 | 158.47 | 118.85 | 79.24 | 59.43 | 47.54 | 23.77 | 15.85 | 11.89 | 9.51 | 6.79 | 4.75 |
| 750 | 509.38 | 254.69 | 169.79 | 127.34 | 84.90 | 63.67 | 50.94 | 25.47 | 16.98 | 12.73 | 10.19 | 7.28 | 5.03 |
| 800 | 543.34 | 271.67 | 181.11 | 135.83 | 90.56 | 67.92 | 54.33 | 27.17 | 18.11 | 13.58 | 10.87 | 7.76 | 5.43 |
| 850 | 577.29 | 288.65 | 192.43 | 144.32 | 96.22 | 72.16 | 57.73 | 28.86 | 19.24 | 14.43 | 11.55 | 8.25 | 5.77 |
| 900 | 611.25 | 305.63 | 203.75 | 152.81 | 101.88 | 76.41 | 61.13 | 30.56 | 20.38 | 15.28 | 12.23 | 8.73 | 6.11 |
| 950 | 645.21 | 322.61 | 215.06 | 161.30 | 107.54 | 80.65 | 64.52 | 32.26 | 21.51 | 16.13 | 12.90 | 9.22 | 6.45 |
| 1000 | 679.17 | 339.58 | 226.38 | 169.79 | 113.20 | 84.90 | 67.92 | 33.96 | 22.64 | 16.98 | 13.58 | 9.70 | 6.79 |

Tableau 3

**Légende :**

| | |
|---|---|
| | Q >1250 |
| | 900< Q <1250 |
| | 600< Q <900 |
| | 300< Q <600 |
| | 150< Q <300 |
| | Q <150 |

$Q_{copmax}$ (W)

| e (mm) \\ L (mm) | 100 | 70 | 50 | 40 | 30 | 20 | 10 | 8 | 6 | 4 | 3 | 2 | 1 |
|---|---|---|---|---|---|---|---|---|---|---|---|---|---|
| 1 | 0.25 | 0.36 | 0.50 | 0.63 | 0.83 | 1.25 | 2.50 | 3.12 | 4.17 | 6.25 | 8.33 | 12.50 | 24.99 |
| 5 | 1.25 | 1.79 | 2.50 | 3.12 | 4.17 | 6.25 | 12.50 | 15.62 | 20.83 | 31.24 | 41.65 | 62.48 | 124.96 |
| 10 | 2.50 | 3.57 | 5.00 | 6.25 | 8.33 | 12.50 | 24.99 | 31.24 | 41.65 | 62.48 | 83.31 | 124.96 | 249.92 |
| 50 | 12.50 | 17.85 | 24.99 | 31.24 | 41.65 | 62.48 | 124.96 | 156.20 | 208.26 | 312.40 | 416.53 | 624.79 | 1249.58 |
| 100 | 24.99 | 35.70 | 49.98 | 62.48 | 83.31 | 124.96 | 249.92 | 312.40 | 416.53 | 624.79 | 833.06 | 1249.58 | 2499.16 |
| 150 | 37.49 | 53.55 | 74.97 | 93.72 | 124.96 | 187.44 | 374.87 | 468.59 | 624.79 | 937.19 | 1249.58 | 1874.37 | 3748.75 |
| 200 | 49.98 | 71.40 | 99.97 | 124.96 | 166.61 | 249.92 | 499.83 | 624.79 | 833.05 | 1249.58 | 1666.11 | 2499.16 | 4998.33 |
| 250 | 62.48 | 89.26 | 124.96 | 156.20 | 208.26 | 312.40 | 624.79 | 780.99 | 1041.32 | 1561.98 | 2082.64 | 3123.95 | 6247.91 |
| 300 | 74.97 | 107.11 | 149.95 | 187.44 | 249.92 | 374.87 | 749.75 | 937.19 | 1249.58 | 1874.37 | 2499.16 | 3748.74 | 7497.49 |
| 350 | 87.47 | 124.96 | 174.94 | 218.67 | 291.55 | 437.35 | 874.71 | 1093.39 | 1457.84 | 2186.76 | 2915.69 | 4373.53 | 8747.07 |
| 400 | 99.97 | 142.81 | 199.93 | 249.92 | 333.22 | 499.83 | 999.66 | 1249.58 | 1666.11 | 2499.16 | 3332.22 | 4998.32 | 9996.66 |
| 450 | 112.46 | 160.66 | 224.92 | 281.16 | 374.88 | 562.31 | 1124.62 | 1405.78 | 1874.37 | 2811.55 | 3748.74 | 5623.11 | 11246.24 |
| 500 | 124.96 | 178.51 | 249.92 | 312.40 | 416.53 | 624.79 | 1249.58 | 1561.98 | 2082.64 | 3123.95 | 4165.27 | 6247.91 | 12495.82 |
| 550 | 137.45 | 196.36 | 274.91 | 343.64 | 458.18 | 687.27 | 1374.54 | 1718.18 | 2290.90 | 3436.34 | 4581.80 | 6872.70 | 13745.40 |
| 600 | 149.95 | 214.21 | 299.90 | 374.88 | 499.83 | 749.75 | 1499.50 | 1874.37 | 2499.16 | 3748.74 | 4998.33 | 7497.49 | 14994.98 |
| 650 | 162.45 | 232.07 | 324.89 | 406.11 | 541.49 | 812.23 | 1624.46 | 2030.57 | 2707.43 | 4061.14 | 5414.85 | 8122.28 | 16244.57 |
| 700 | 174.94 | 249.92 | 349.88 | 437.35 | 583.14 | 874.71 | 1749.41 | 2186.77 | 2915.69 | 4373.53 | 5831.38 | 8747.07 | 17494.15 |
| 750 | 186.44 | 267.77 | 374.87 | 468.59 | 624.79 | 937.19 | 1874.37 | 2342.97 | 3123.95 | 4685.93 | 6247.91 | 9371.86 | 18743.73 |
| 800 | 199.93 | 285.62 | 399.87 | 499.83 | 666.44 | 999.66 | 1999.33 | 2499.16 | 3332.22 | 4998.32 | 6664.44 | 9996.65 | 19993.31 |
| 850 | 212.43 | 303.47 | 424.86 | 531.07 | 708.10 | 1062.14 | 2124.29 | 2655.36 | 3540.48 | 5310.72 | 7080.96 | 10621.45 | 21242.89 |
| 900 | 224.92 | 321.32 | 449.85 | 562.31 | 749.75 | 1124.62 | 2249.25 | 2811.56 | 3748.74 | 5623.12 | 7497.49 | 11246.24 | 22492.48 |
| 950 | 237.42 | 339.17 | 474.84 | 593.55 | 791.40 | 1187.10 | 2374.21 | 2967.76 | 3957.01 | 5935.51 | 7914.02 | 11871.03 | 23742.06 |
| 1000 | 249.92 | 357.02 | 499.83 | 624.79 | 833.05 | 1249.58 | 2499.16 | 3123.95 | 4165.27 | 6247.91 | 8330.55 | 12495.82 | 24991.64 |

Tableau 4

**EP 2 592 668 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 1455340 A
- US 4859250 A
- WO 2009023776 A
- JP 8032124 B
- US 6759587 B
- FR 1160289